# EUROPEAN PATENT APPLICATION

(11) **EP 4 261 909 A1**
(43) Date of publication of application: **18.10.2023**
(21) Application number: 21903465.9
(22) Date of filing: 09.12.2021
(51) Int. Cl.: H01L 51/50, C07D 487/04, C09K 11/06, H05B 33/10

(54) **ORGANIC ELECTROLUMINESCENT ELEMENT**

(30) Priority: 11.12.2020 JP 2020206182
(71) Applicant: NIPPON STEEL Chemical & Material Co., Ltd., Tokyo 103-0027 (JP)
(72) Inventor: KITAHARA, Ikumi, Tokyo 103-0027 (JP); HAYASHI, Kentaro, Tokyo 103-0027 (JP); OGAWA, Junya, Tokyo 103-0027 (JP); UEDA, Tokiko, Tokyo 103-0027 (JP)
(74) Representative: Vossius & Partner Patentanwälte Rechtsanwälte mbB
(86) International application number: PCT/JP2021/045320
(87) International publication number: WO 2022/124366

(57) **Abstract**

To provide an organic electroluminescent device (organic EL device) that is driven at a low voltage and that has high efficiency and lifetime characteristics. The organic EL device includes a light-emitting layer between an anode and a cathode opposed to each other, in which the light-emitting layer contains a first host selected from an indolocarbazole compound having a triphenylene ring-containing group with which an N-position of an indolocarbazole ring is directly or indirectly substituted, a second host selected from a biscarbazole compound having a structure in which two carbazole rings are linked at a carbon position, and a light-emitting dopant material.

## Description

### Technical Field

The present invention relates to an organic electroluminescent element or device (hereinafter, referred to as an organic EL device), and specifically relates to an organic EL device comprising a specific mixed host material.

### Background Art

Application of a voltage to an organic EL device allows injection of holes and electrons from an anode and a cathode, respectively, into a light-emitting layer. Then, in the light-emitting layer, injected holes and electrons recombine to generate excitons. At this time, according to statistical rules of electron spins, singlet excitons and triplet excitons are generated at a ratio of 1:3. Regarding a fluorescence-emitting organic EL device using light emission from singlet excitons, it is said that the internal quantum efficiency thereof has a limit of 25%. Meanwhile, regarding a phosphorescent organic EL device using light emission from triplet excitons, it is known that intersystem crossing is efficiently performed from singlet excitons, the internal quantum efficiency is enhanced to 100%.

Highly efficient organic EL devices utilizing delayed fluorescence have been developed recently. For example, Patent Literature 1 discloses an organic EL device utilizing a TTF (Triplet-Triplet Fusion) mechanism, which is one of delayed fluorescence mechanisms. The TTF mechanism utilizes a phenomenon in which singlet excitons are generated due to collision of two triplet excitons, and it is thought that the internal quantum efficiency can be theoretically raised to 40%. However, since the efficiency is lower compared to phosphorescent organic EL devices, further improvement in efficiency and low voltage characteristics are required.

In addition, patent Literature 2 discloses an organic EL device utilizing a TADF (Thermally Activated Delayed Fluorescence) mechanism. The TADF mechanism utilizes a phenomenon in which reverse intersystem crossing from triplet excitons to singlet excitons is generated in a material having a small energy difference between a singlet level and a triplet level, and it is thought that the internal quantum efficiency can be theoretically raised to 100%.

However, all the mechanisms have room for advancement in terms of both efficiency and lifetime, and are additionally required to be improved also in terms of reduction in driving voltage.

### Citation List

### Patent Literature

Patent Literature 1: WO2010/134350 A
Patent Literature 2: WO2011/070963 A
Patent Literature 3: WO2008/056746 A
Patent Literature 4: WO2008/146839 A
Patent Literature 5: WO2013/056776 A
Patent Literature 6: JP2012-140365 A
Patent Literature 7: JP2003-133075 A
Patent Literature 8: US2015/0236262 A
Patent Literature 9: WO2012/039561 A
Patent Literature 10: WO2018/198844 A
Patent Literature 11: WO2015/034125 A

Patent Literatures 3 and 4 disclose use of a compound in which indolocarbazole is substituted with a nitrogen-containing 6-membered ring, as a host material of a light-emitting layer. Patent Literatures 5 and 6 disclose use of a compound in which indolocarbazole is substituted with triphenylene, as a host material. Patent Literature 7 discloses use of a biscarbazole compound as a host material.

Patent Literatures 8, 9, and 10 disclose use of a mixed host material comprising an indolocarbazole compound, in a light-emitting layer.

Patent Literature 11 discloses use of a mixed host material of a triphenylene compound and a carbazole compound, in a light-emitting layer.

However, none of these can be said to be sufficient, and further improvement is desired.

### Summary of Invention

Organic EL displays, when compared with liquid crystal displays, are not only characterized by being thin-and-light, high in contrast, and capable of displaying a high-speed moving picture, but also highly valued in terms of designability such as curving and flexibility, and are widely applied in display apparatuses including mobiles and TV. However, organic EL displays are needed to be further reduced in voltage in order to suppress battery consumption in the case of use thereof for mobile terminals, and are inferior as light sources in terms of luminance and lifetime as compared with inorganic LEDs and thus are demanded to be improved in efficiency and stability during driving. In view of the above circumstances, an object of the present invention is to provide a practically useful organic EL device having a low voltage, high efficiency and lifetime characteristics.

As a result of intensive studies, the present inventors have found that the above problems can be solved by an organic EL device in which a specific mixed host material is used in a light-emitting layer, and have completed the present invention.

The present invention relates to an organic EL device comprising one or more light-emitting layers between an anode and a cathode opposed to each other, wherein at least one of the light-emitting layers contains a first host selected from a compound represented by the following general formula (1), a second host selected from a compound represented by the following general formula (2), and a light-emitting dopant material.

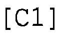

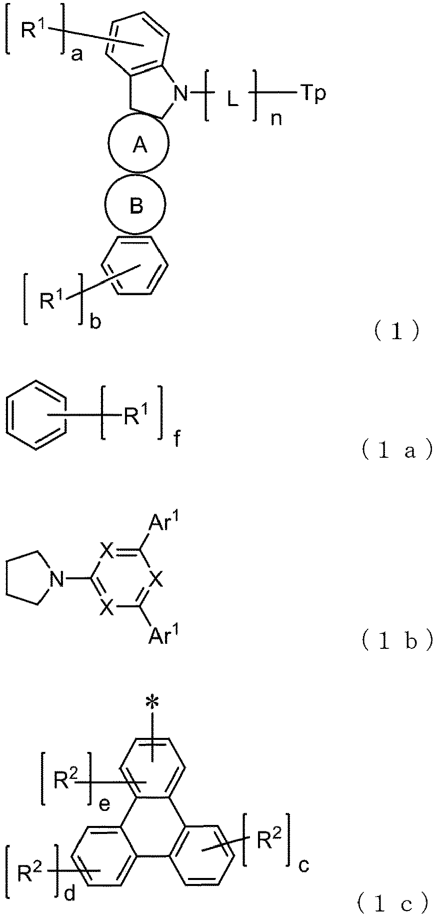

In the general formula (1), a ring A is an aromatic ring represented by formula (1a), a ring B is a heterocycle represented by formula (1b), Tp represents a group represented by formula (1c), and * represents a position for binding to L.

Each R¹ independently represents deuterium, or an aliphatic hydrocarbon group having 1 to 10 carbon atoms.

L represents a substituted or unsubstituted aromatic hydrocarbon group having 6 to 18 carbon atoms.

Each X independently represents N or C-H and at least one thereof represents N.

Each Ar¹ independently represents hydrogen, a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five of these aromatic rings are linked to each other.

Each R² independently represents deuterium, an aliphatic hydrocarbon group having 1 to 10 carbon atoms, a substituted or unsubstituted aromatic hydrocarbon group having 6 to 10 carbon atoms, a substituted or unsubstituted aromatic heterocyclic group having 3 to 17 carbon atoms, or a substituted or unsubstituted linked aromatic group in which two to five aromatic rings of aromatic groups selected from the aromatic hydrocarbon group and the aromatic heterocyclic group are linked to each other.
a to f represent the number of substitutions, a to d represent an integer of 0 to 4, e represents an integer of 0 to 3, and f represents an integer of 0 to 2.
n represents the number of repetitions and an integer of 0 to 3. 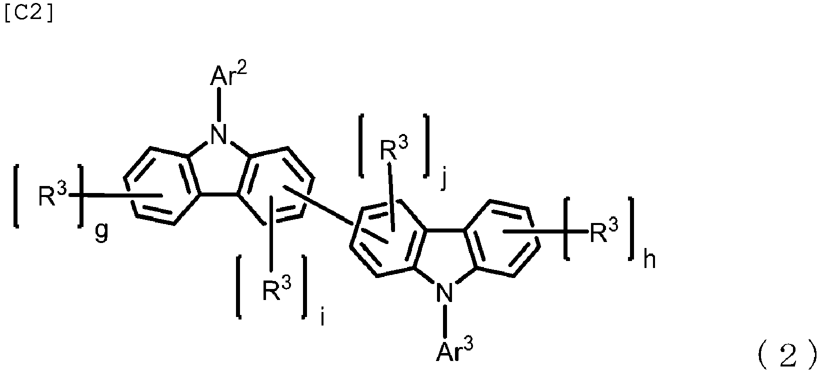
In the general formula (2), Ar² and Ar³ each independently represent a substituted or unsubstituted aromatic hydrocarbon group having 6 to 18 carbon atoms, or a substituted or unsubstituted aromatic heterocyclic group having 3 to 17 carbon atoms, or a substituted or unsubstituted linked aromatic group in which two to five of these aromatic groups are linked to each other.

Each R³ independently represents deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms.
g to j represent the number of substitutions, g and h represent an integer of 0 to 4, and i and j represent an integer of 0 to 3.

In preferred aspects, for example, all of X represent N, L represents a substituted or unsubstituted phenylene group, n represents 0 or 1, or a to f represent 0, in the general formula (1).

The compound represented by the general formula (1) is preferably represented by any of the following formulas (3) to (6): 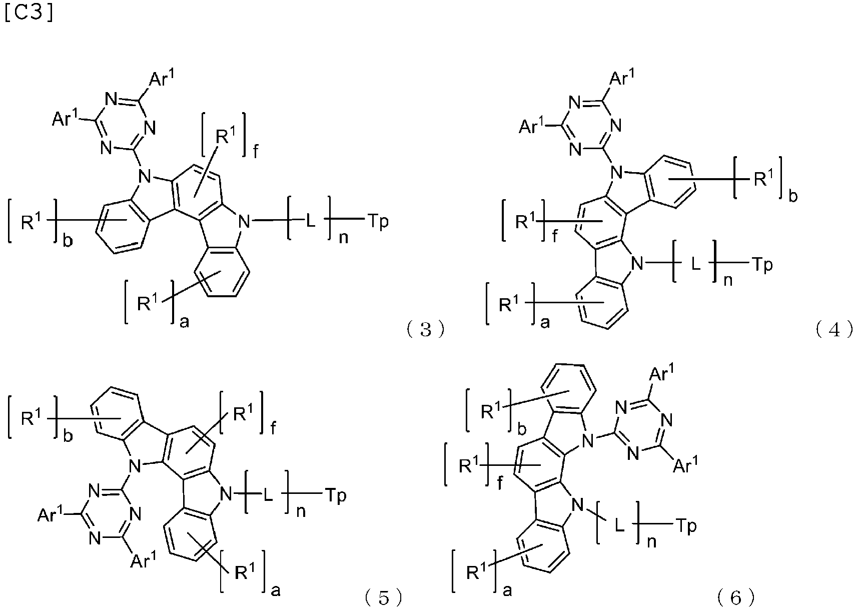 wherein Tp, Ar¹, L, R¹, a, b, f, and n are as defined for the general formula (1).

Tp in the general formula (1) and the formulas (3) to (6) is preferably represented by the following formula (1d) : 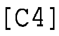 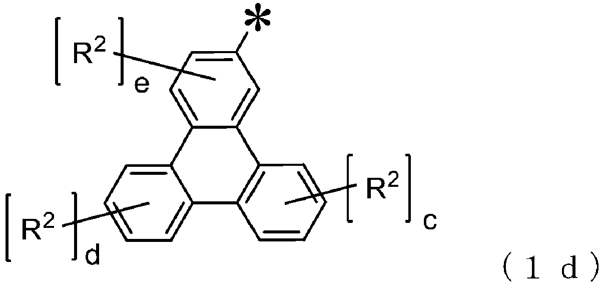 wherein R², c, d, and e are as defined for the general formula (1).

The compound represented by the general formula (2) is preferably represented by the following formula (7): 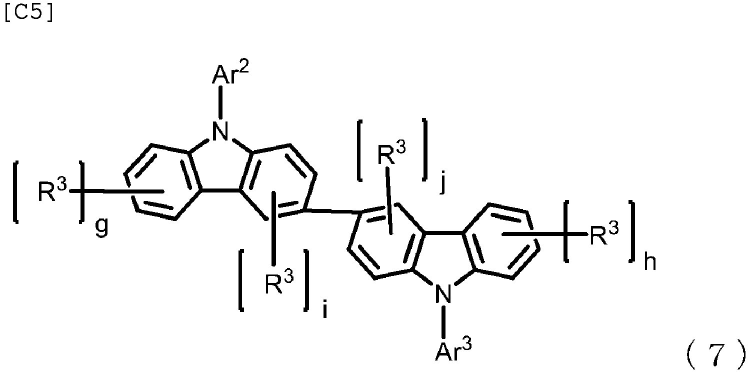 wherein Ar², Ar³, R³, and g to j are as defined for the general formula (2).

In preferred aspects, in the general formula (2) or the formula (7), all of g to j represent 0, or Ar² and Ar³ represent a substituted or unsubstituted phenyl group, biphenyl group, or terphenyl group.

The light-emitting dopant material can be an organic metal complex containing at least one metal selected from ruthenium, rhodium, palladium, silver, rhenium, osmium, iridium, platinum and gold, or can be a thermally activated delayed fluorescence-emitting dopant material.

The present invention also relates to a method for producing the organic EL device, comprising a step of mixing the first host and the second host to form a premixture and then vapor-depositing a host material containing the premixture to form a light-emitting layer.

A difference in 50% weight reduction temperatures of the first host and the second host in the premixture is preferably within 20°C. The premixture can be used for the method for producing the organic EL device.

The present invention also relates to a premixture comprising the first host and the second host, wherein a difference in 50% weight reduction temperatures of the first host and the second host is within 20°C.

According to the present invention, a compound having a nitrogen-containing 6-membered ring and a triphenylene group in indolocarbazole, and a biscarbazole compound can be mixed and used to thereby obtain an organic EL device having high efficiency and extended lifetime while having a low voltage.

### Brief Description of Drawing

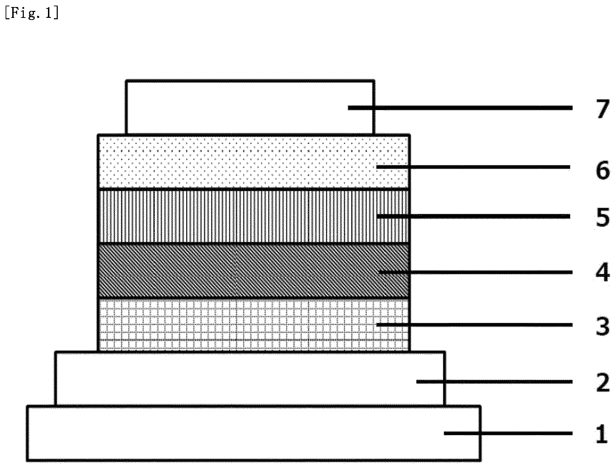

[Figure 1] Figure 1 is a schematic cross-sectional view showing one example of an organic EL device.

### Description of Embodiments

An organic EL device of the present invention is an organic EL device having a plurality of organic layers between an anode and a cathode, wherein the organic layers comprise at least one light-emitting layer, and such a light-emitting layer contains the first host represented by the general formula (1), the second host represented by the general formula (2), and a dopant material.

In the general formula (1), a ring A represents a benzene ring represented by formula (1a), and a ring B represents a 5-membered heterocycle represented by formula (1b) and is fused to two adjacent rings at any positions, but is not fused at a side containing N. Hence, an indolocarbazole ring has some isomeric structures, but the number of the structures is restricted.

Specifically, any structure represented by the formulas (3) to (6) can be adopted. Preferred is a compound represented by the formula (6).

In the general formula (1) and the formulas (3) to (6), the same symbols have the same meaning. The general formula (1) is interpreted to encompass the formula (1a), the formula (1b), the formula (1c) and the formula (1d).

Each X independently represents N or C-H and at least one thereof represents N. Preferably, two or more X represent N. More preferably, all of X represent N.

a to f represent the number of substitutions, a to d represent an integer of 0 to 4, e represents an integer of 0 to 3, and f represents an integer of 0 to 2. Preferably, a to f represent an integer of 0 to 2, and more preferably, all of a to f represent 0.

n represents the number of repetitions and an integer of 0 to 3. Preferred is an integer of 1 to 3, and more preferred is 1 or 2.

Each Ar¹ independently represents hydrogen, a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five of these aromatic rings are linked to each other. Preferred is a substituted or unsubstituted aromatic hydrocarbon group having 6 to 10 carbon atoms, a substituted or unsubstituted aromatic heterocyclic group having 3 to 12 carbon atoms, or a substituted or unsubstituted linked aromatic group in which two to five of the aromatic hydrocarbon groups are linked to each other. More preferred is a substituted or unsubstituted phenyl group, or a substituted or unsubstituted linked aromatic group in which two to three phenyl groups are linked to each other.

Specific examples of the unsubstituted aromatic hydrocarbon group having 6 to 18 carbon atoms, the unsubstituted aromatic heterocyclic group having 3 to 17 carbon atoms, or the linked aromatic group in which two to five of these aromatic rings are linked to each other include a group generated by removing one hydrogen from benzene, naphthalene, acenaphthene, acenaphthylene, azulene, anthracene, chrysene, pyrene, phenanthrene, fluorene, triphenylene, pyridine, pyrimidine, triazine, thiophene, isothiazole, thiazole, pyridazine, pyrrole, pyrazole, imidazole, triazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, or compounds in which two to five of these are linked to each other. Preferred examples thereof include a group generated from benzene, naphthalene, acenaphthene, acenaphthylene, azulene, anthracene, chrysene, pyrene, phenanthrene, fluorene, triphenylene, or compounds in which two to five of these are linked to each other. More preferred is a phenyl group, a biphenyl group, or a terphenyl group. The terphenyl group may be linked linearly or branched.

L represents a substituted or unsubstituted aromatic hydrocarbon group having 6 to 18 carbon atoms. L is preferably represented by a substituted or unsubstituted phenylene group, more preferably an unsubstituted phenylene group. When n represents 2 or 3, L has a linked structure, and the linking scheme may be any of ortho-, meta-, or para-linking. Herein, the linked structure is a structure in which aromatic hydrocarbon rings are bound by a single bond.

When L represents an unsubstituted aromatic hydrocarbon group having 6 to 18 carbon atoms, the same as in the case of Ar¹ being an unsubstituted aromatic hydrocarbon group having 6 to 18 carbon atoms is applied except that a divalent group generated by removing two hydrogen atoms from an aromatic hydrocarbon compound is adopted. Preferred is a substituted or unsubstituted phenylene group.

Each R¹ independently represents deuterium, or an aliphatic hydrocarbon group having 1 to 10 carbon atoms. Preferred is deuterium or an aliphatic hydrocarbon group having 1 to 4 carbon atoms, and more preferred is deuterium.

Specific examples of the aliphatic hydrocarbon group having 1 to 10 carbon atoms include methyl, ethyl, propyl, isopropyl, butyl, t-butyl, pentyl, neopentyl, hexyl, heptyl, octyl, nonyl, and decyl. Preferred is methyl, ethyl, t-butyl, or neopentyl, and more preferred is methyl.

In the general formula (1), Tp represents a triphenylene group represented by formula (1c). Preferred is a triphenylene group represented by formula (1d) .

Each R² independently represents deuterium, an aliphatic hydrocarbon group having 1 to 10 carbon atoms, a substituted or unsubstituted aromatic hydrocarbon group having 6 to 10 carbon atoms, a substituted or unsubstituted aromatic heterocyclic group having 3 to 17 carbon atoms, or a substituted or unsubstituted linked aromatic group in which two to five of these aromatic rings are linked to each other. Preferred is deuterium, a substituted or unsubstituted phenyl group, a substituted or unsubstituted aromatic heterocyclic group having 3 to 12 carbon atoms, or a substituted or unsubstituted linked aromatic group in which two to five of these aromatic rings are linked to each other, and more preferred is a substituted or unsubstituted phenyl group, or a substituted or unsubstituted aromatic heterocyclic group having 3 to 12 carbon atoms.

Specific examples of the aliphatic hydrocarbon group having 1 to 10 carbon atoms are the same as in the case of R¹ being an aliphatic hydrocarbon group having 1 to 10 carbon atoms.

Specific examples of the unsubstituted aromatic hydrocarbon group having 6 to 10 carbon atoms, the unsubstituted aromatic heterocyclic group having 3 to 17 carbon atoms, or the linked aromatic group in which two to five of these aromatic rings are linked to each other include a group generated from benzene, azulene, phenanthrene, pyridine, pyrimidine, triazine, thiophene, isothiazole, thiazole, pyridazine, pyrrole, pyrazole, imidazole, triazole, pyrazine, furan, isoxazole, quinoline, isoquinoline, quinoxaline, quinazoline, thiadiazole, phthalazine, tetrazole, indole, benzofuran, benzothiophene, benzoxazole, benzothiazole, indazole, benzimidazole, benzotriazole, benzisothiazole, benzothiadiazole, purine, pyranone, coumarin, isocoumarin, chromone, dibenzofuran, dibenzothiophene, dibenzoselenophene, carbazole, or compounds in which two to five of these are linked to each other.

Preferred examples thereof include an aromatic group generated from benzene, pyridine, pyrimidine, triazine, thiophene, isothiazole, thiazole, pyridazine, pyrrole, pyrazole, imidazole, triazole, thiadiazole, pyrazine, furan, isoxazole, oxazole, oxadiazole, quinoline, isoquinoline, quinoxaline, quinazoline, oxadiazole, thiadiazole, benzotriazine, phthalazine, tetrazole, indole, benzofuran, benzothiophene, benzoxazole, benzothiazole, indazole, benzimidazole, benzotriazole, benzisothiazole, benzothiadiazole, or compounds in which two to five of these are linked to each other. More preferred examples thereof include an aromatic group generated from benzene, pyridine, pyrimidine, triazine, thiophene, isothiazole, thiazole, pyridazine, pyrrole, pyrazole, imidazole, triazole, thiadiazole, pyrazine, furan, isoxazole, oxazole, or oxadiazole.

In the present specification, the linked aromatic group refers to an aromatic group in which the carbon atoms of the aromatic rings in two or more aromatic groups are linked to each other by a single bond. The linked aromatic group may be linear or branched, and is preferably linear. The linkage position in linking of benzene rings may be any of the ortho-, meta-, and para-positions, and is preferably the para-position or the meta-position. The aromatic group may be an aromatic hydrocarbon group or an aromatic heterocyclic group, and the plurality of aromatic groups may be the same or different. The aromatic group corresponding to the linked aromatic group is different from the substituted aromatic group.

In the present specification, an aromatic hydrocarbon group, an aromatic heterocyclic group, or a linked aromatic group may each have a substituent. In the case of having a substituent, the substituent is preferably deuterium, halogen, a cyano group, a triarylsilyl group, an aliphatic hydrocarbon group having 1 to 10 carbon atoms, an alkenyl group having 2 to 5 carbon atoms, an alkoxy group having 1 to 5 carbon atoms, or a diarylamino group having 12 to 44 carbon atoms. In the case of the aliphatic hydrocarbon group having 1 to 10 carbon atoms, the substituent may be linear, branched, or cyclic. When the aromatic ring of the aromatic hydrocarbon group, the aromatic heterocyclic group, or the linked aromatic group is substituted with the triarylsilyl group or the diarylamino group, silicon and carbon, or nitrogen and carbon are each bound by a single bond.

Note that the number of substituents is 0 to 5 and preferably 0 to 2. When an aromatic hydrocarbon group and an aromatic heterocyclic group have substituents, the calculation of the number of carbon atoms does not include the number of carbon atoms of the substituents. However, it is preferred that the total number of carbon atoms including the number of carbon atoms of substituents satisfy the above range.

Specific examples of the substituent include cyano, methyl, ethyl, propyl, i-propyl, butyl, t-butyl, pentyl, neopentyl, cyclopentyl, hexyl, cyclohexyl, heptyl, octyl, nonyl, decyl, vinyl, propenyl, butenyl, pentenyl, methoxy, ethoxy, propoxy, butoxy, pentoxy, diphenylamino, naphthylphenylamino, dinaphthylamino, dinthranylamino, diphenanthrenylamino, and dipyrenylamino. Preferred examples thereof include cyano, methyl, ethyl, t-butyl, propyl, butyl, pentyl, neopentyl, hexyl, heptyl, or octyl, diphenylamino, naphthylphenylamino, or dinaphthylamino.

Some or all hydrogen atoms of the unsubstituted aromatic hydrocarbon group, the unsubstituted aromatic heterocyclic group, the unsubstituted linked aromatic group, the substituents of these aromatic groups, or the aliphatic hydrocarbon group may be deuterated. Some or all hydrogen atoms in the general formulas (1) and (2), the formulas (1a) to (1d), and the formulas (3) to (7) may be deuterated.

Specific examples of the compounds represented by the general formula (1) are shown below, but are not limited to these exemplified compounds.

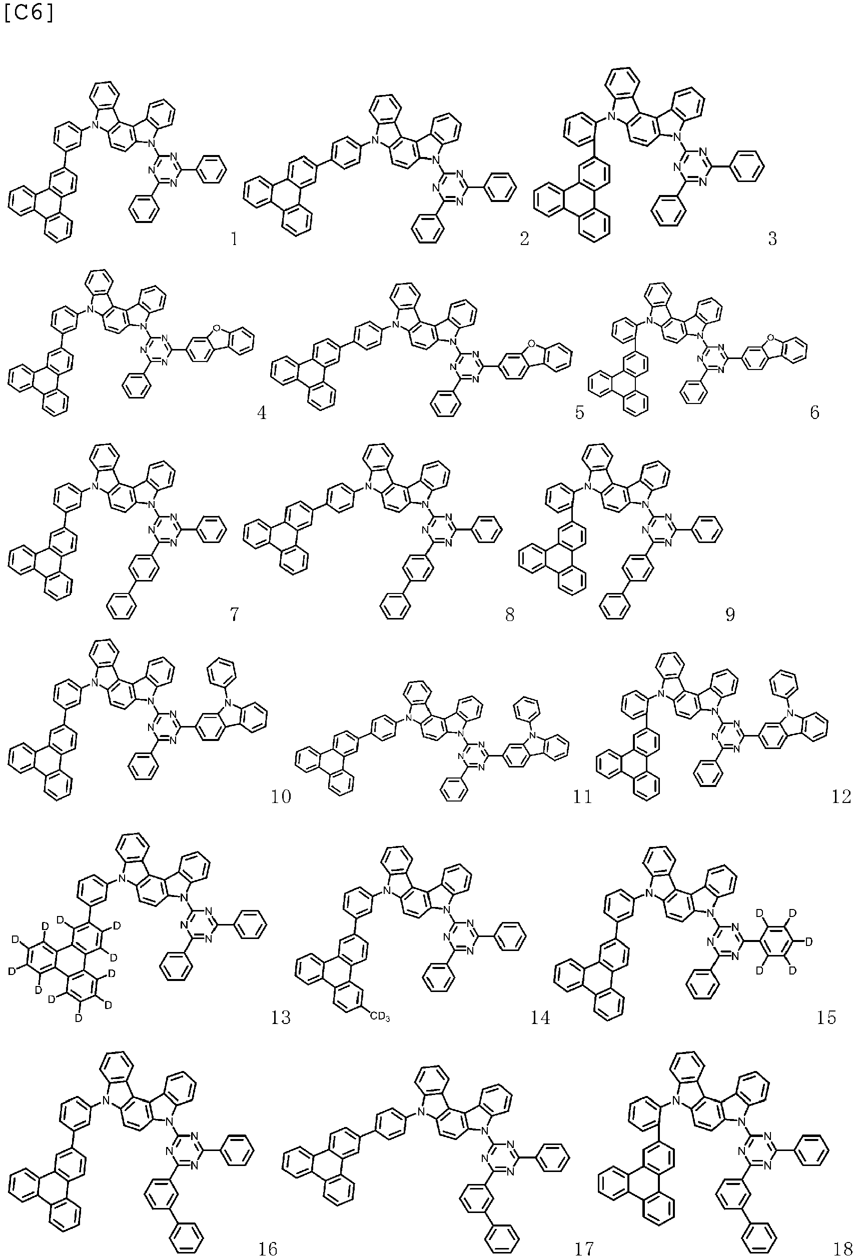

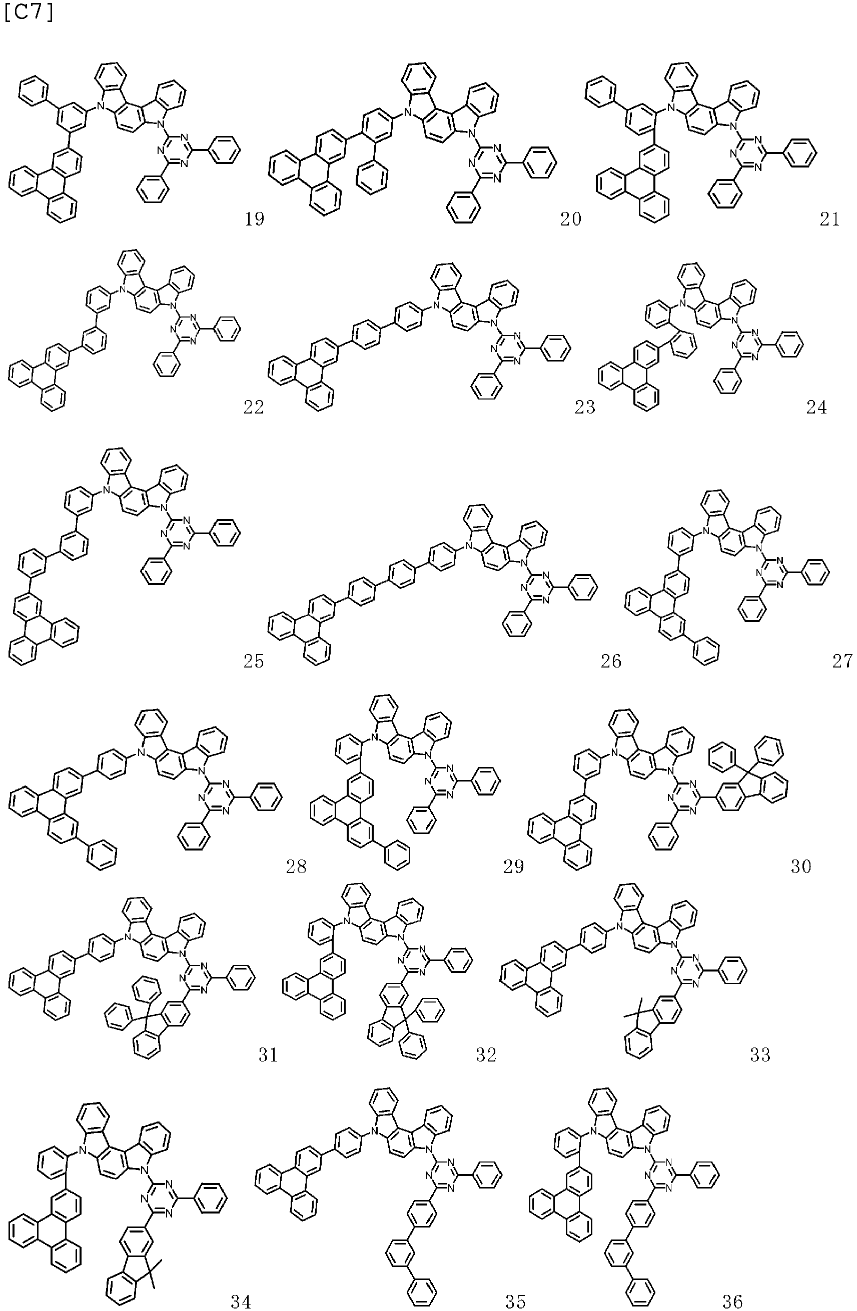

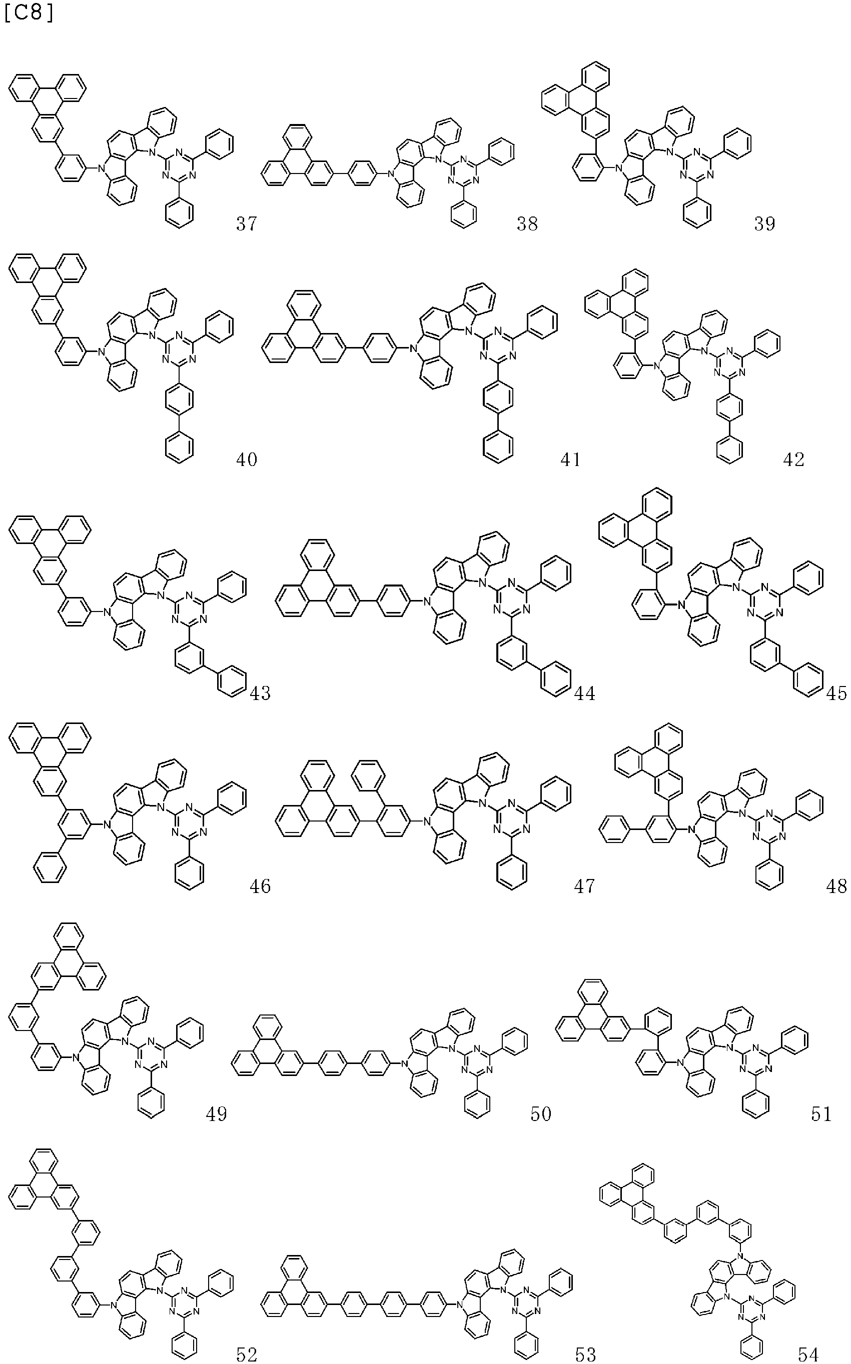

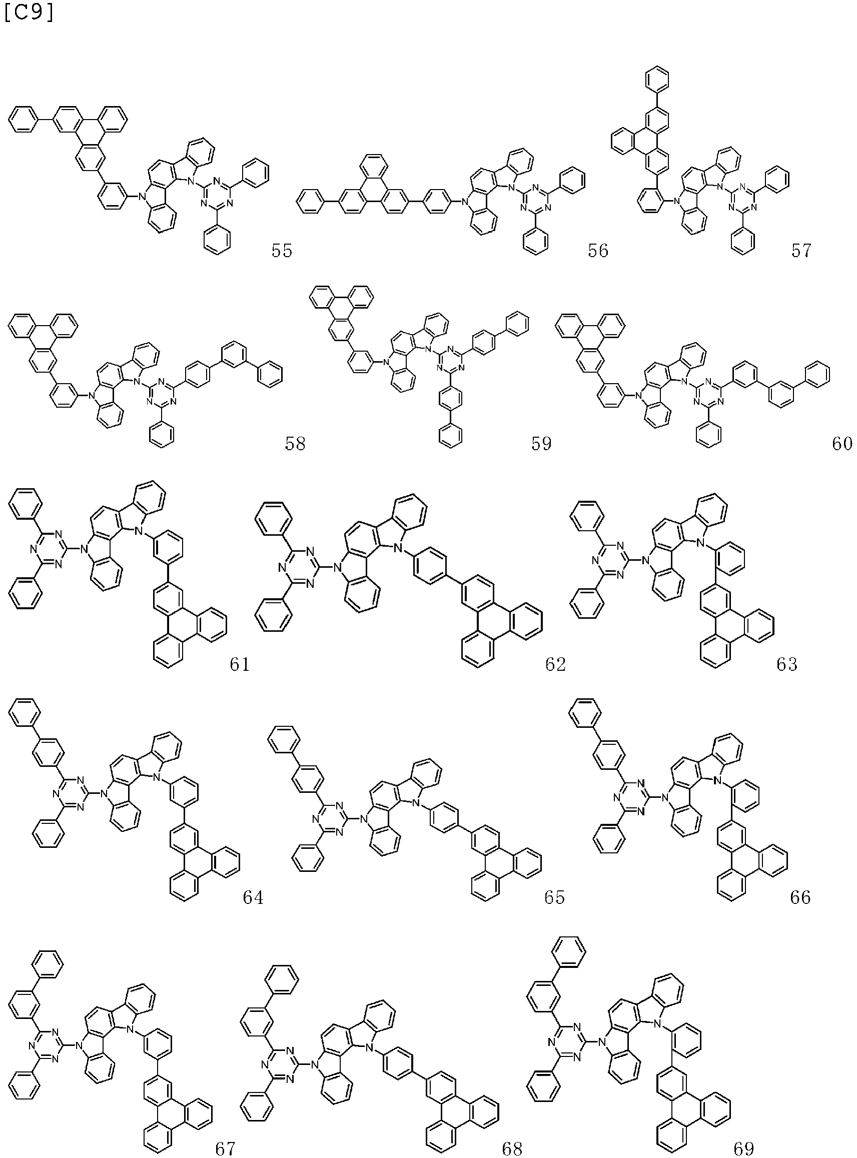

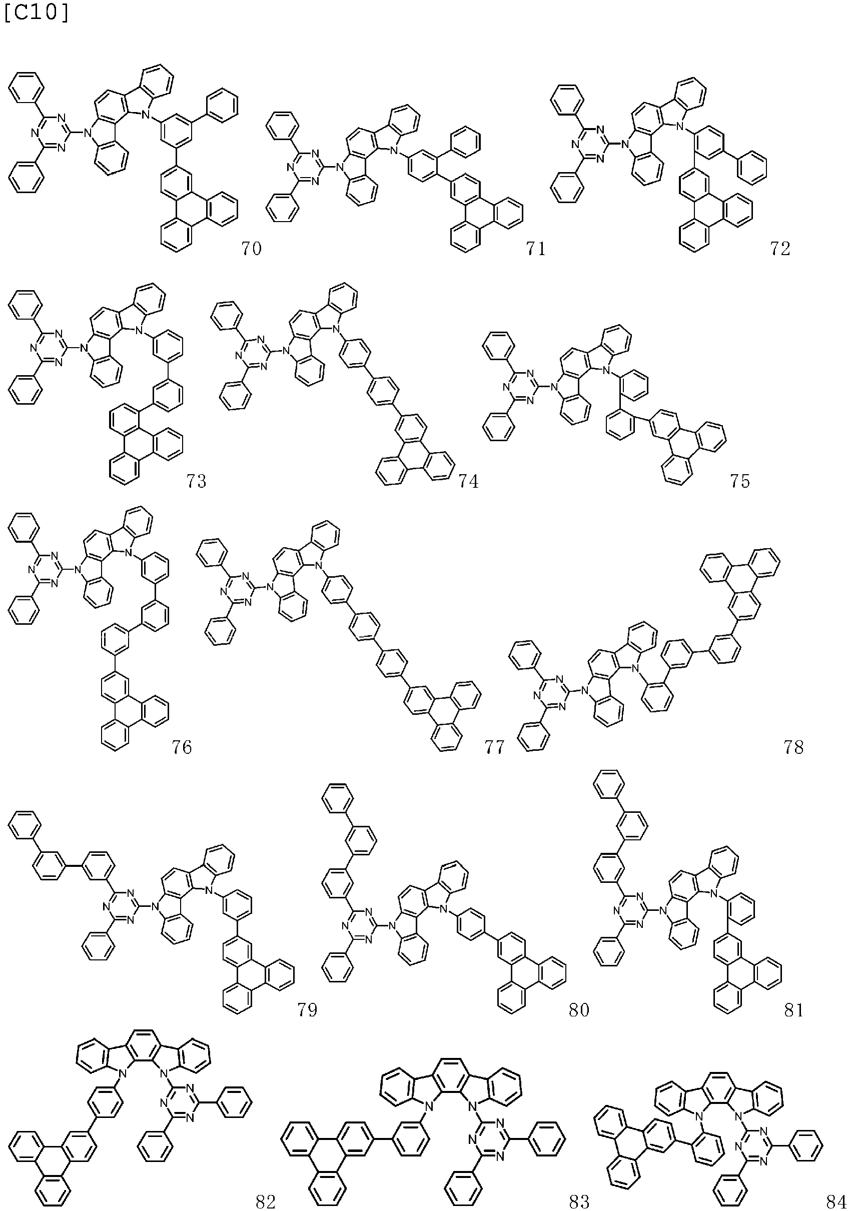

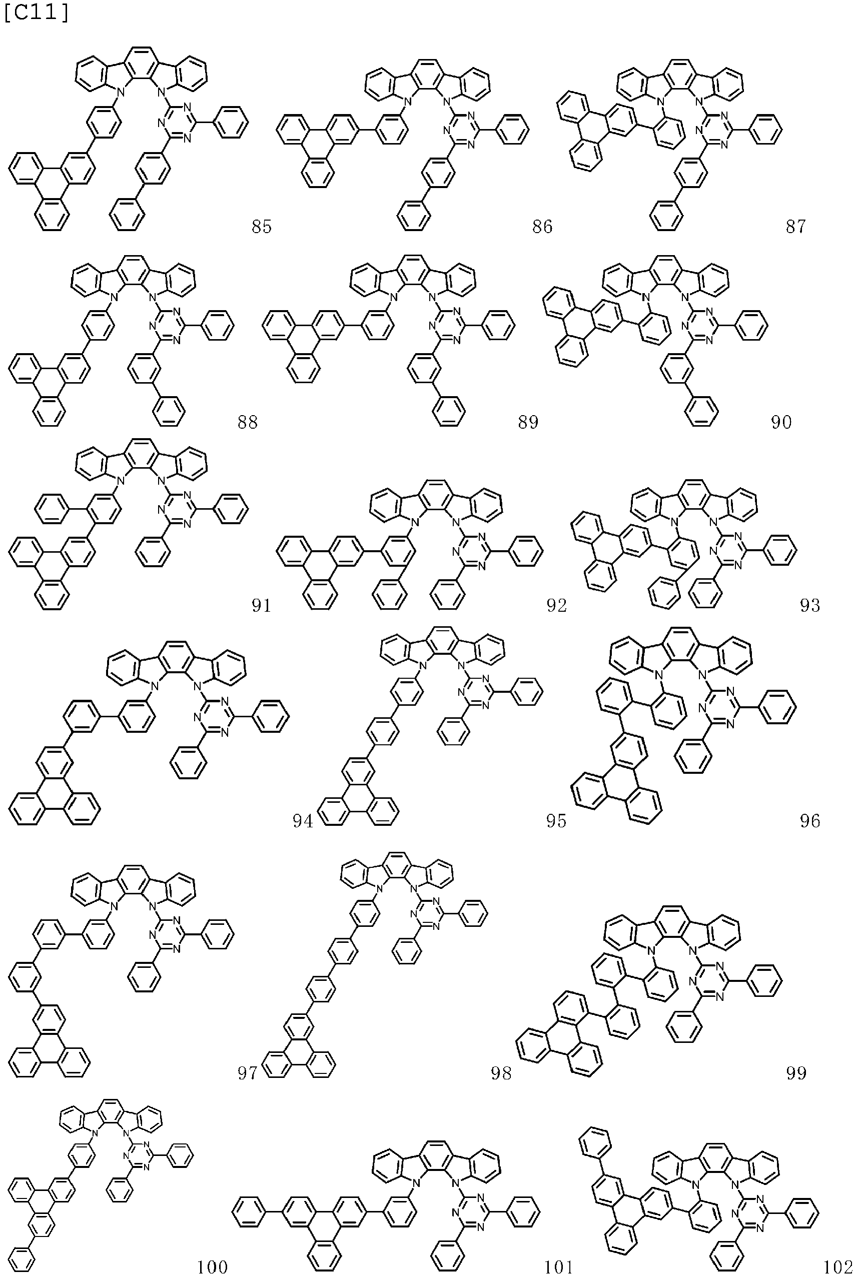

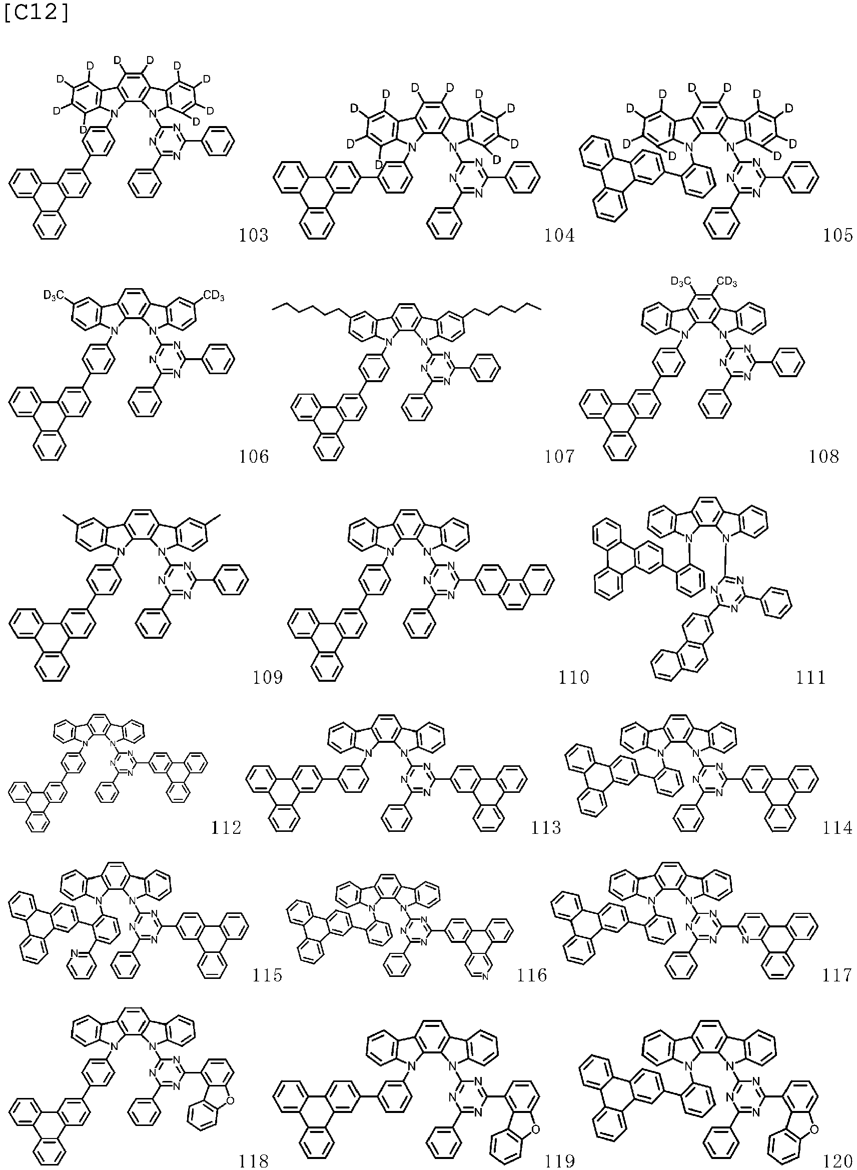

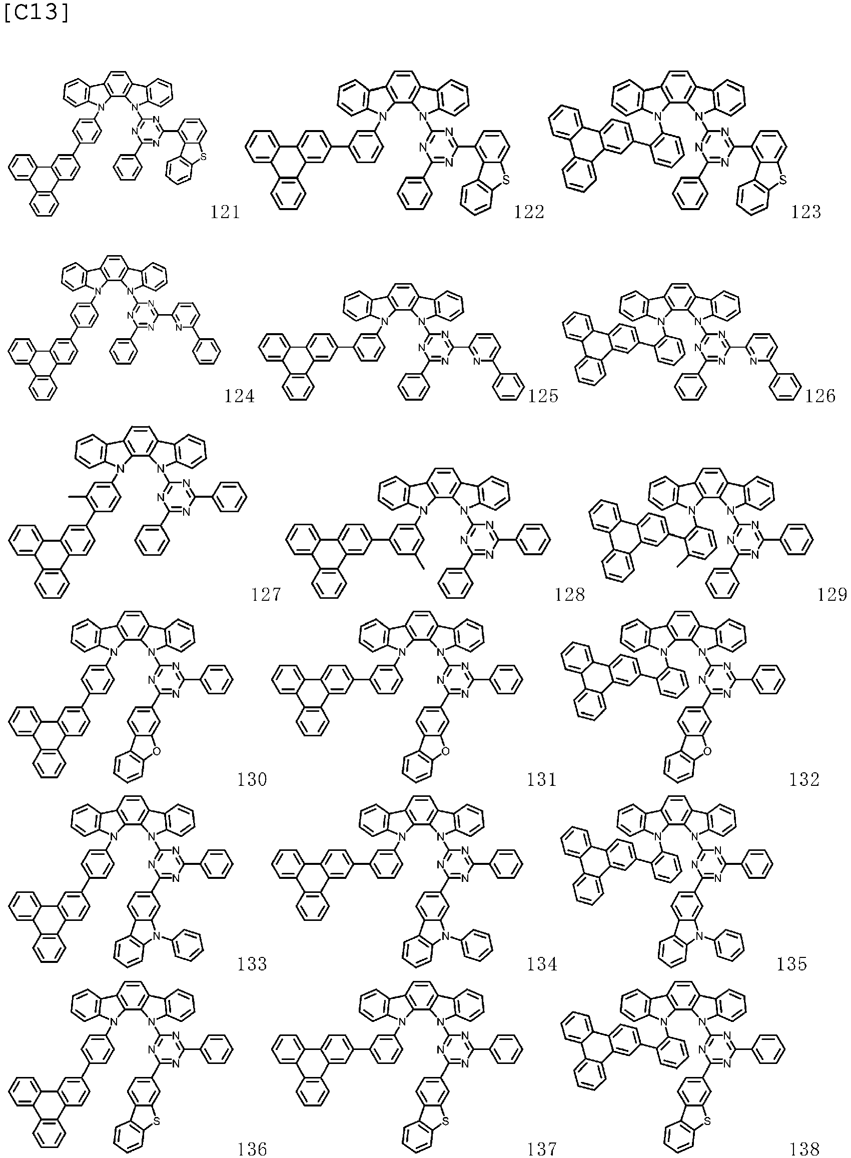

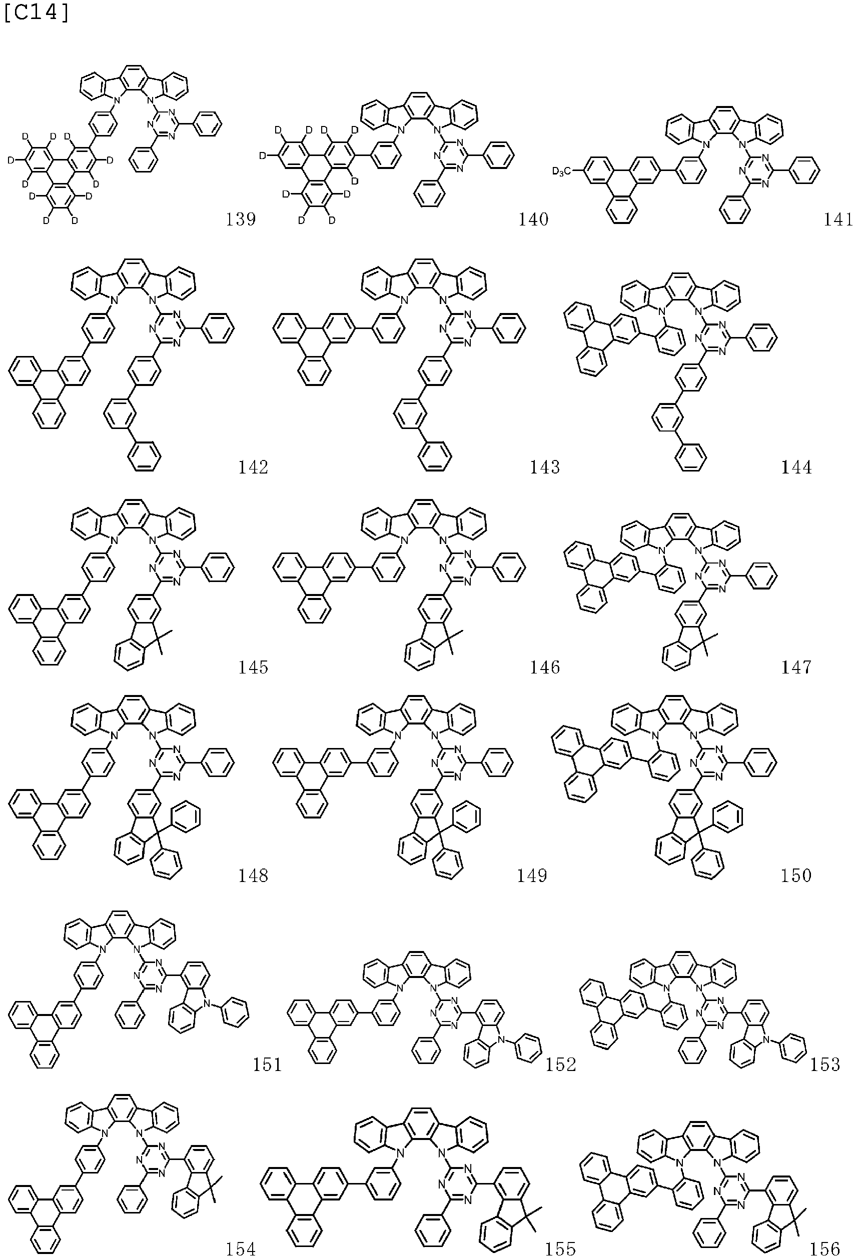

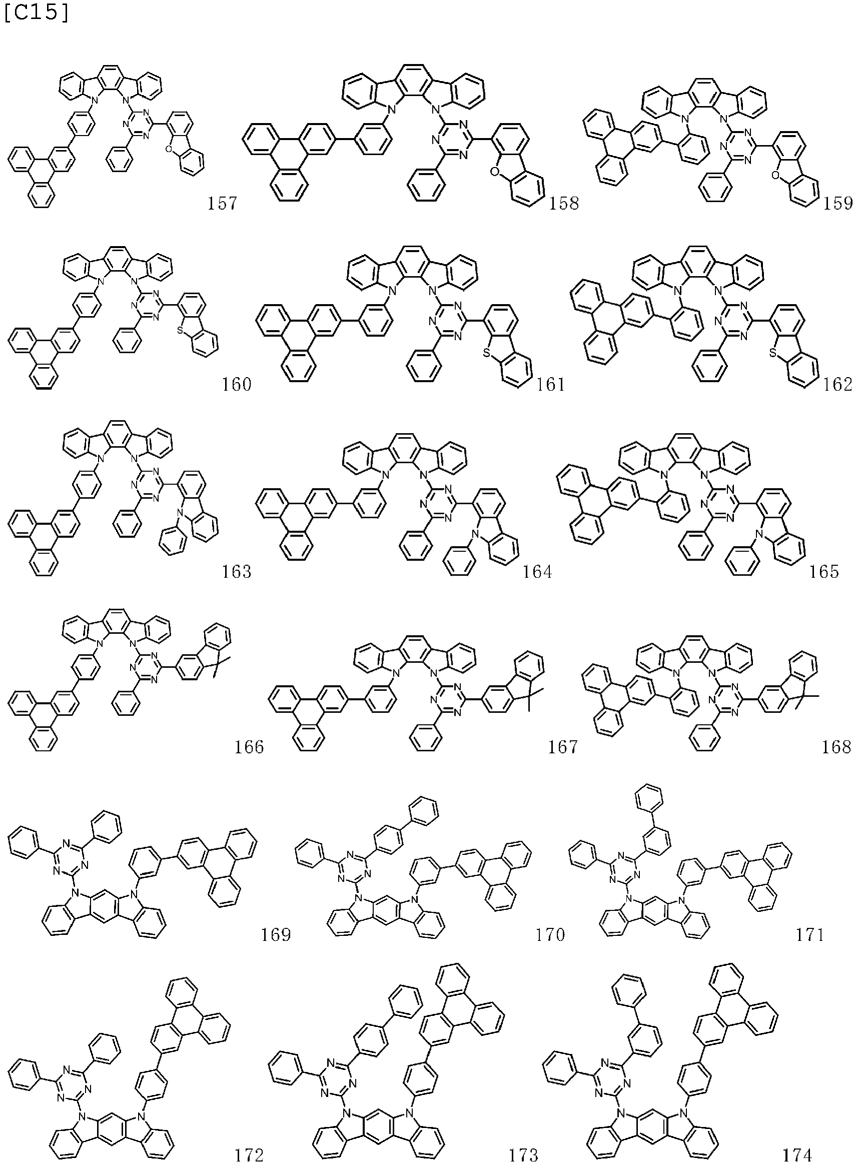

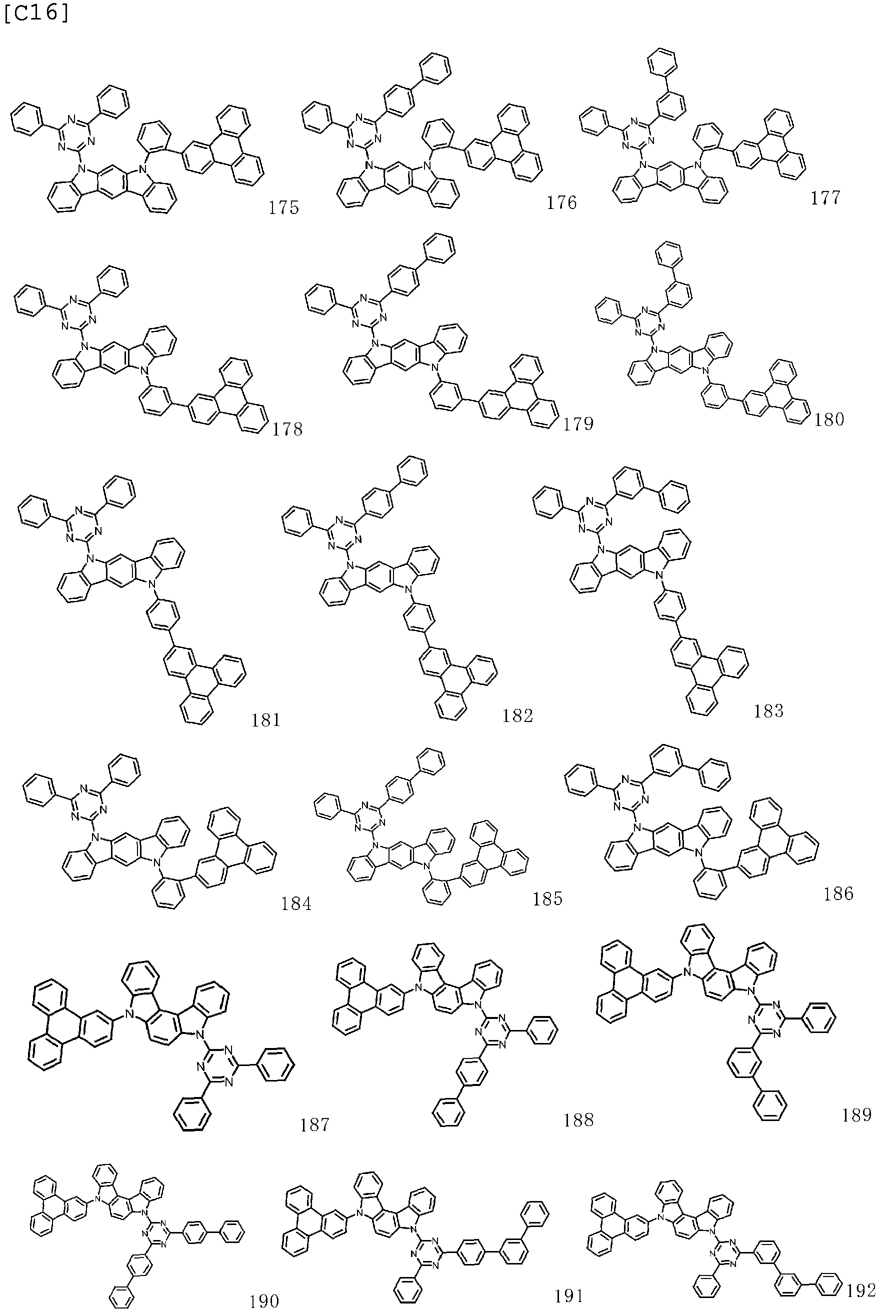

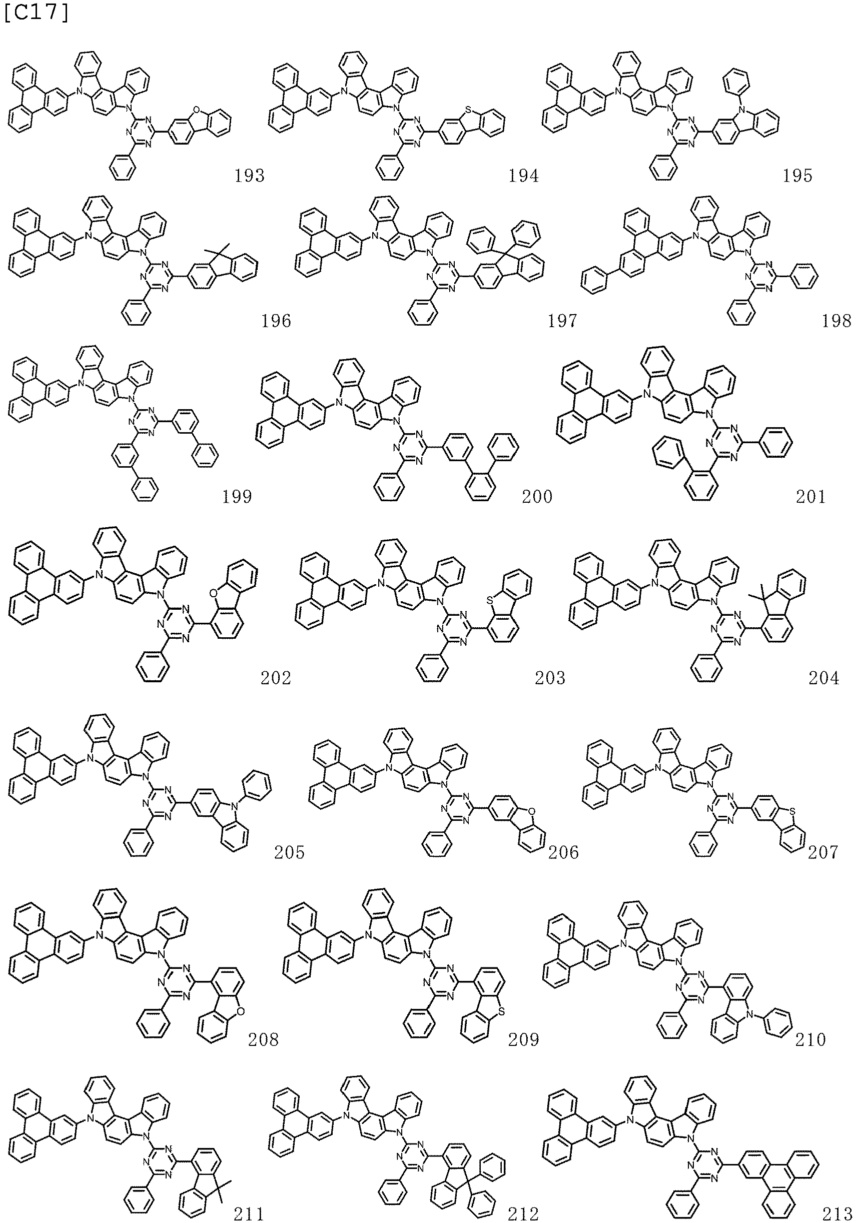

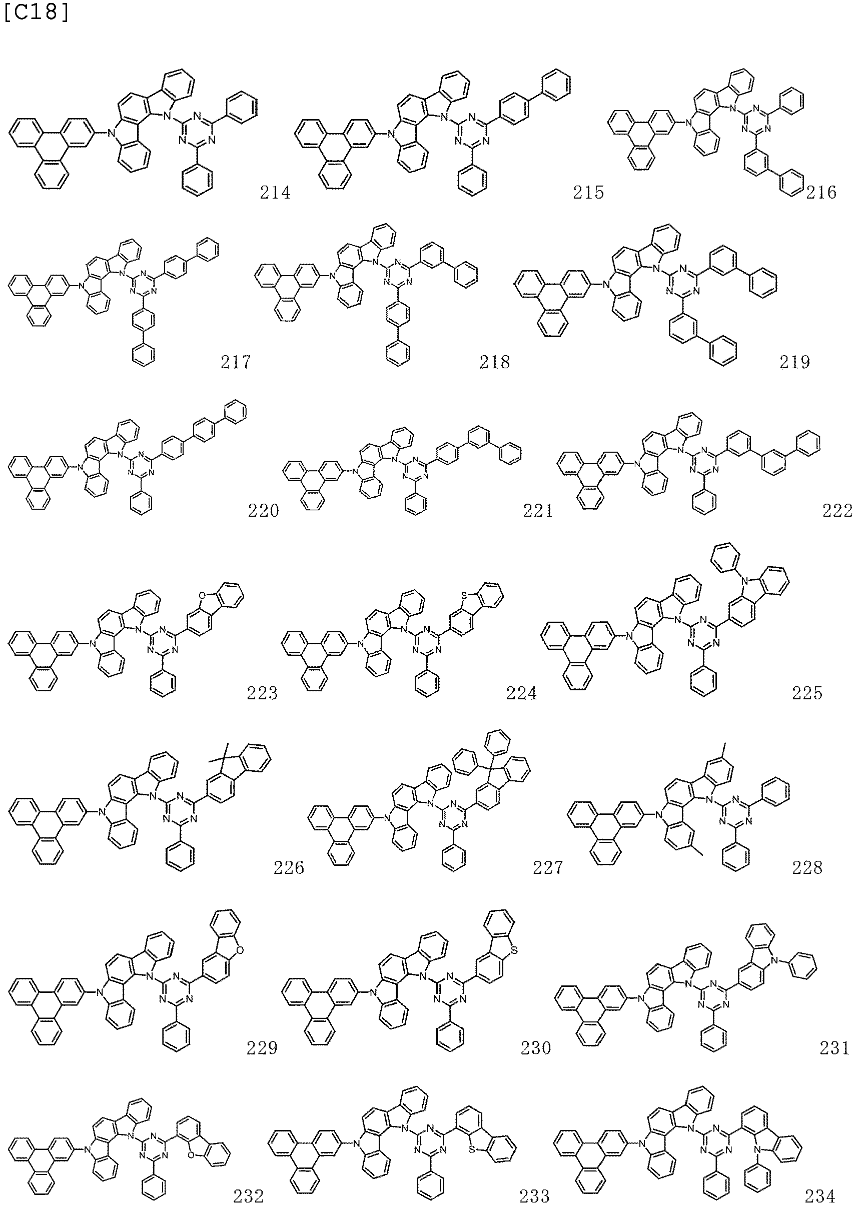

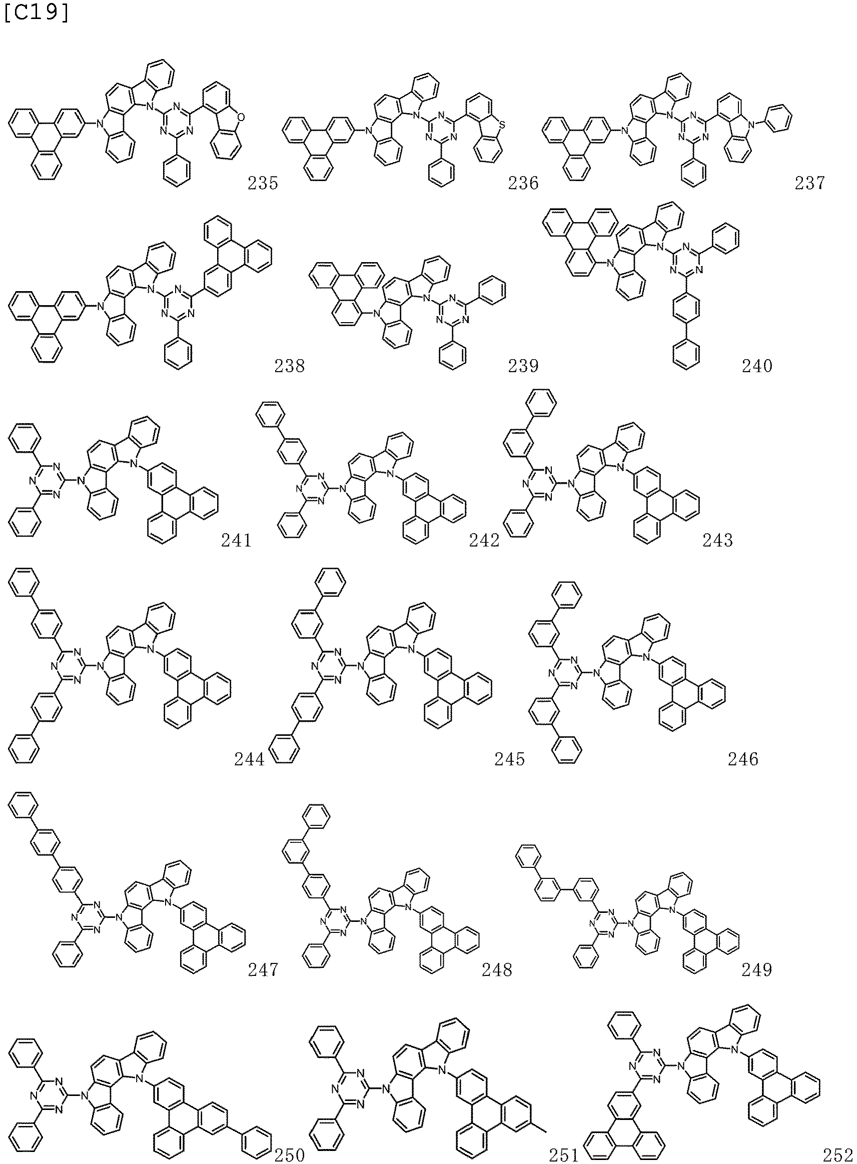

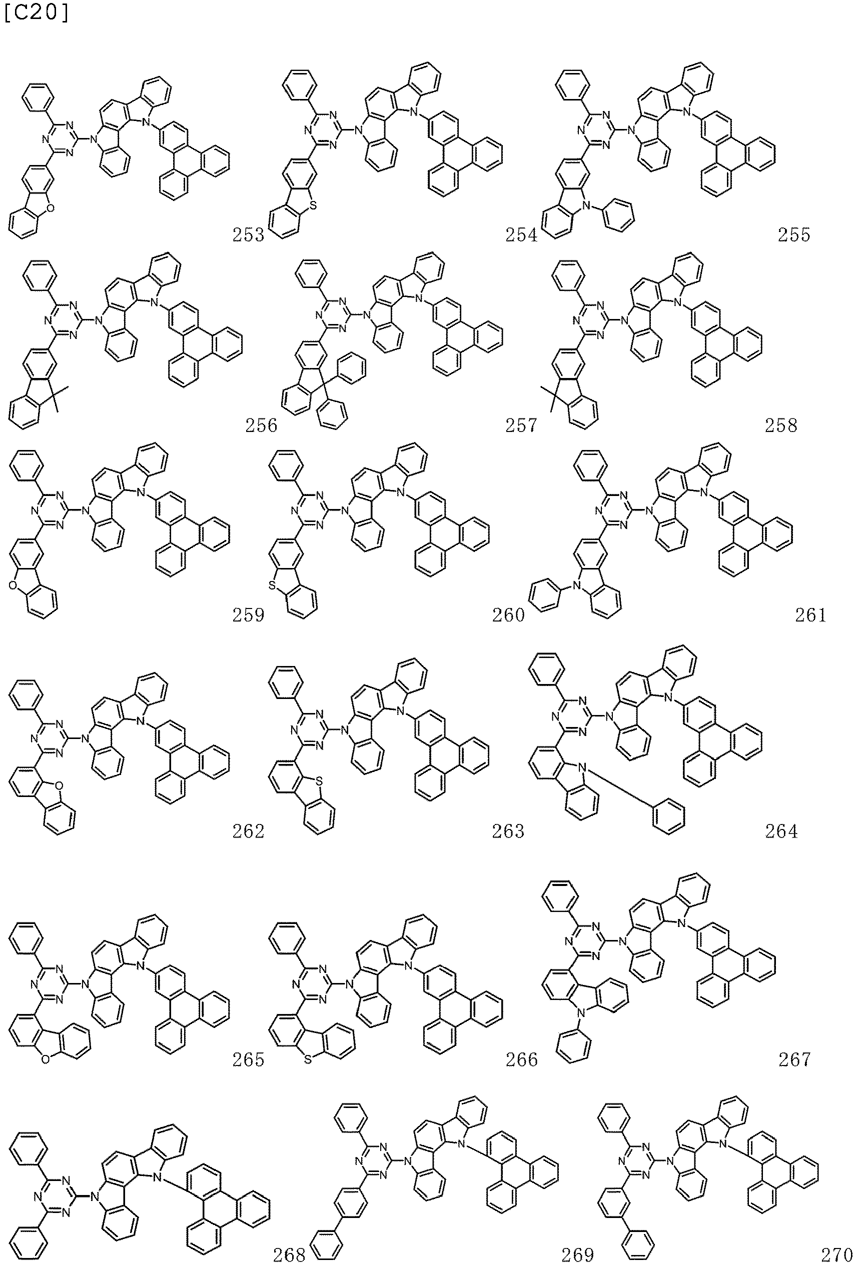

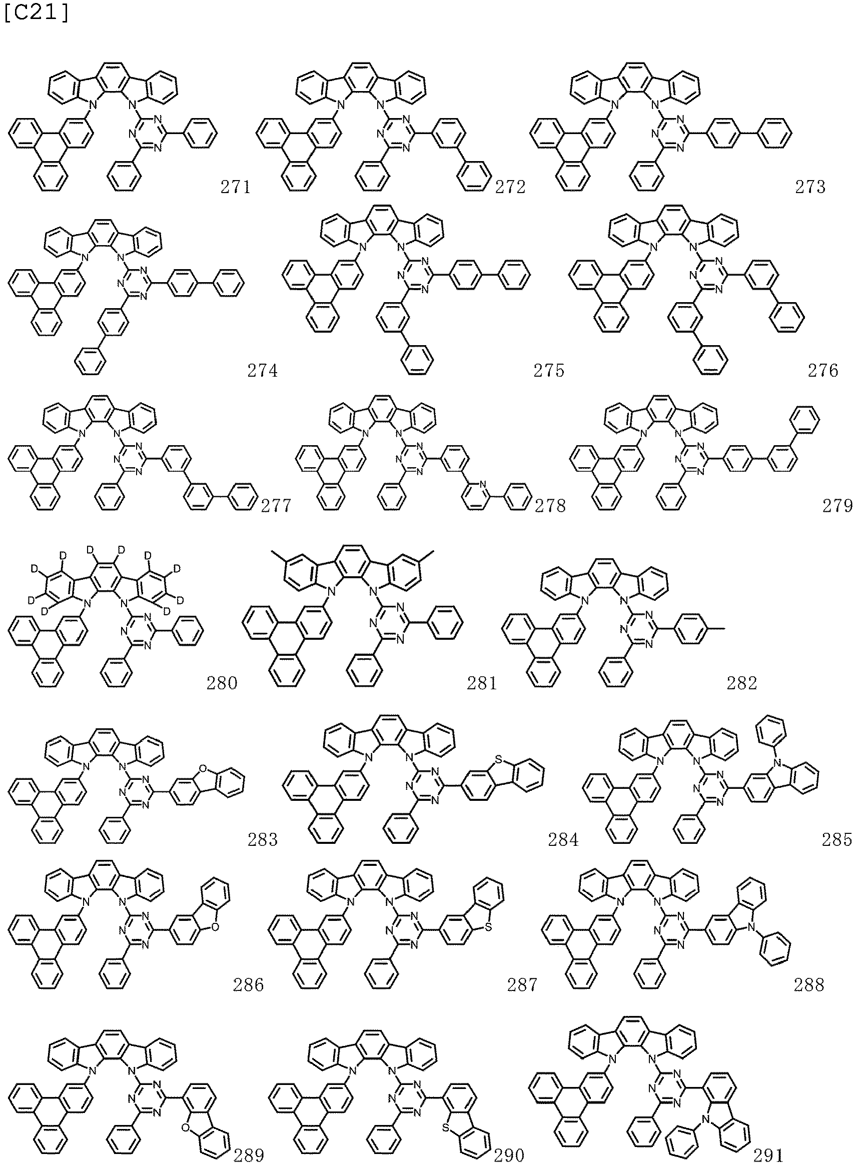

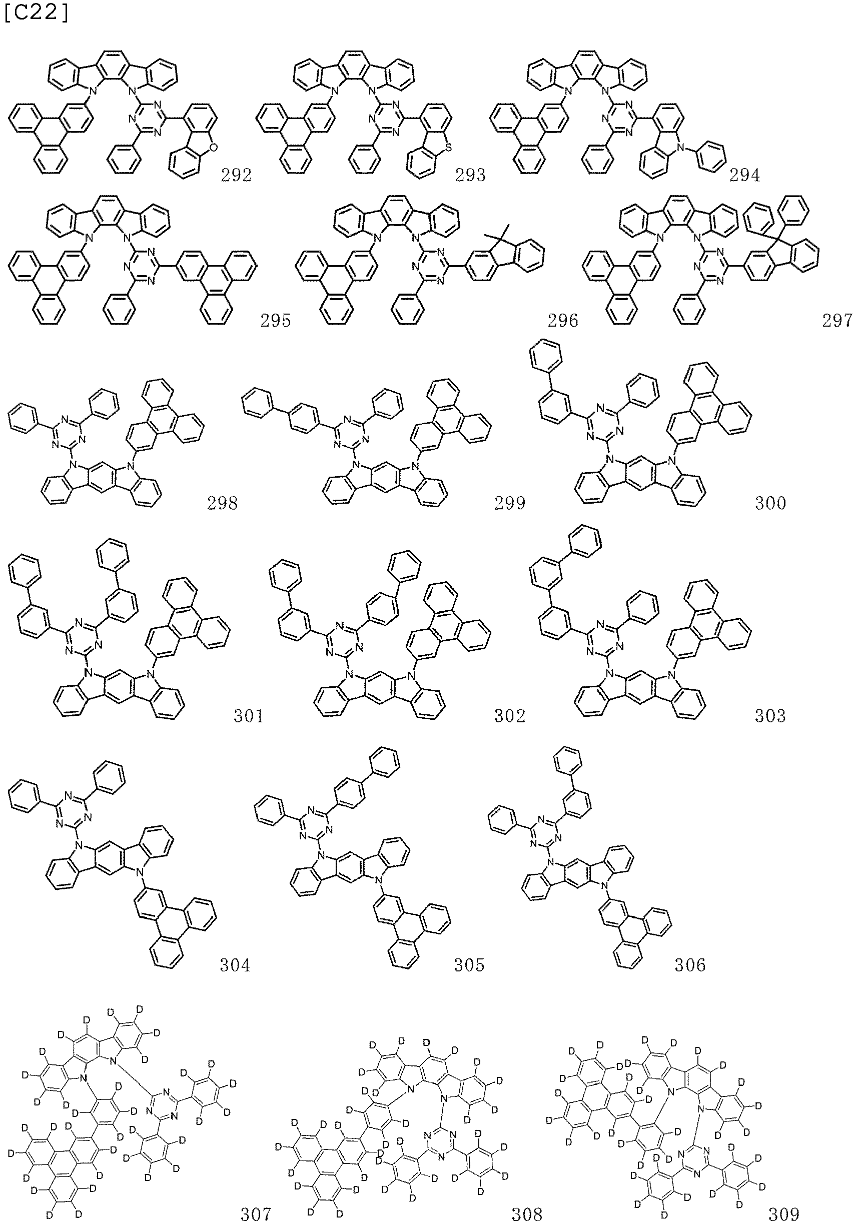

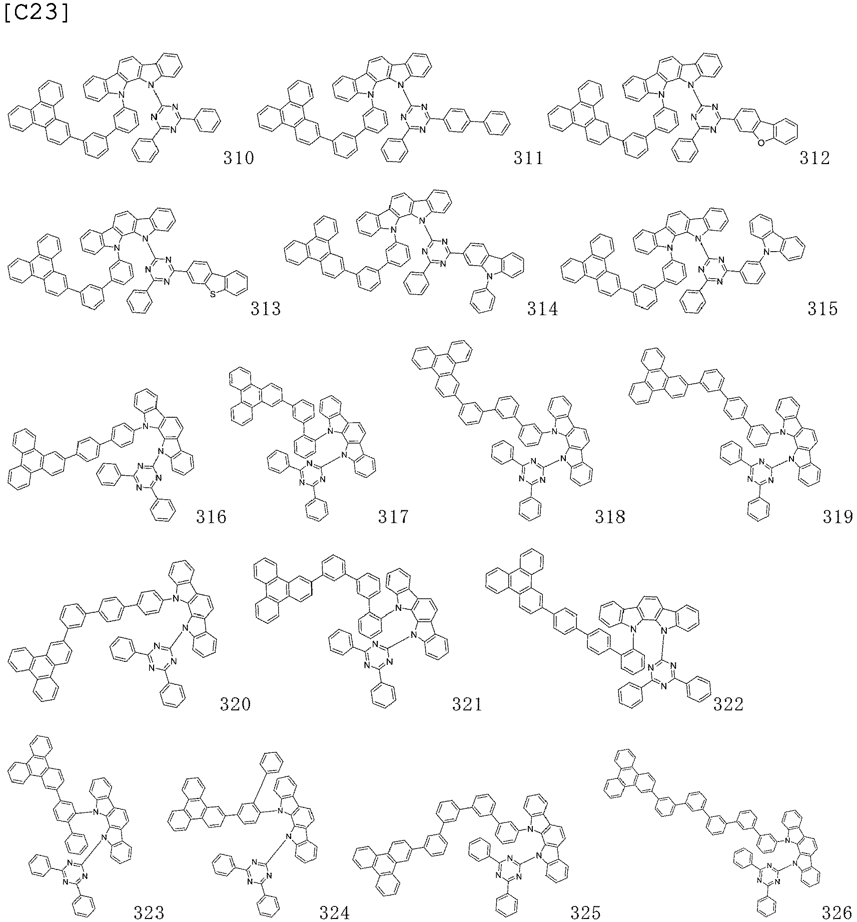

In the general formula (2), two carbazole rings can be each bound at the 2-position, the 3-position, or the 4-position, and are preferably each bound at the 3-position as represented by the formula (7).

In the general formula (2) and the formula (7), the same symbols have the same meaning.

Ar² and Ar³ each independently represent a substituted or unsubstituted aromatic hydrocarbon group having 6 to 18 carbon atoms, or a substituted or unsubstituted aromatic heterocyclic group having 3 to 17 carbon atoms, or a substituted or unsubstituted linked aromatic group in which two to five of these aromatic groups are linked to each other. Preferred is a substituted or unsubstituted aromatic hydrocarbon group having 6 to 18 carbon atoms, or a linked aromatic group in which two to three of the aromatic hydrocarbon groups are linked to each other, and more preferred is a substituted or unsubstituted phenyl group, biphenyl group, or terphenyl group.

Each R³ independently represents deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms. Preferred is deuterium, or a substituted or unsubstituted aromatic hydrocarbon group having 6 to 18 carbon atoms, and more preferred is a substituted or unsubstituted phenyl group.

g to j represent the number of substitutions, g and h represent an integer of 0 to 4, and i and j represent an integer of 0 to 3. Preferably, g and h represent an integer of 0 to 2 and i and j represent an integer of 0 to 1, and more preferably all of g to j represent 0.

Specific examples of the unsubstituted aromatic hydrocarbon group having 6 to 18 carbon atoms, the unsubstituted aromatic heterocyclic group having 3 to 17 carbon atoms, the unsubstituted linked aromatic group in which two to five of the aromatic hydrocarbon groups and the aromatic heterocyclic groups are linked to each other, and the substituent are the same as described with respect to the general formula (1).

Specific examples of the compounds represented by the general formula (2) are shown below, but are not limited to these exemplified compounds.

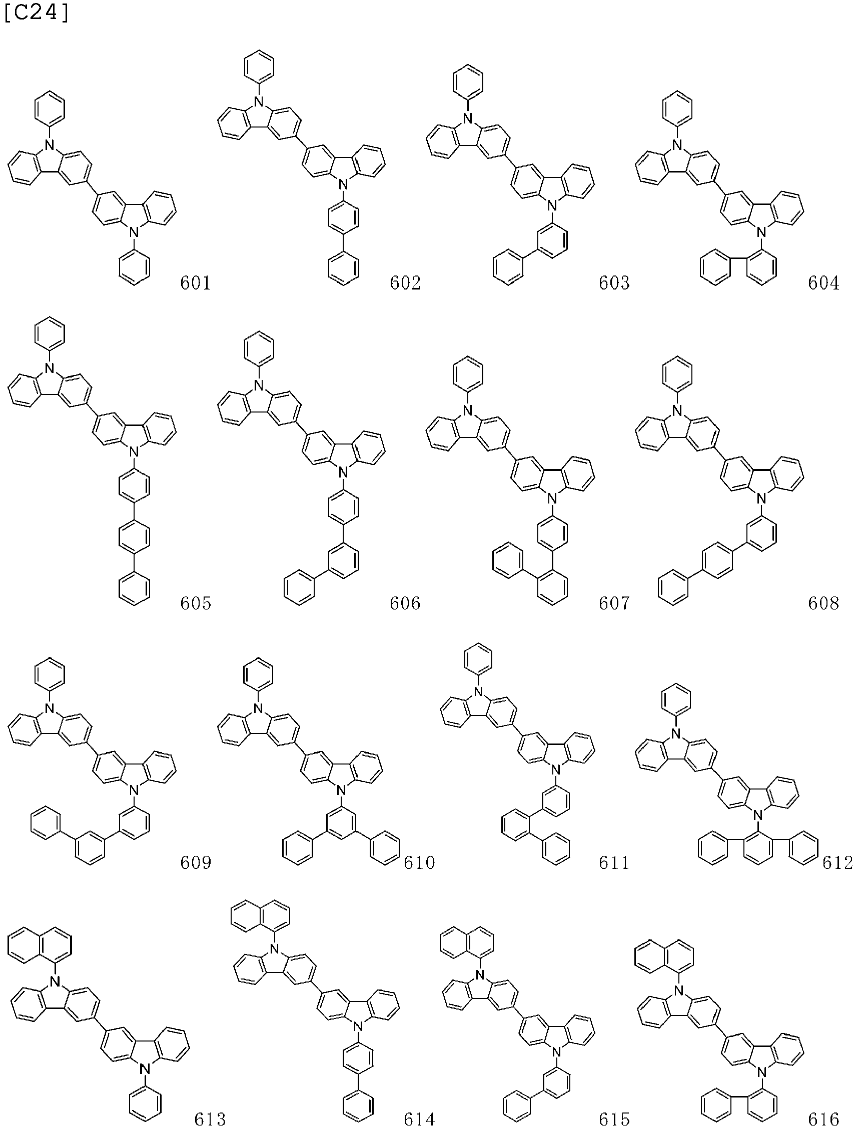

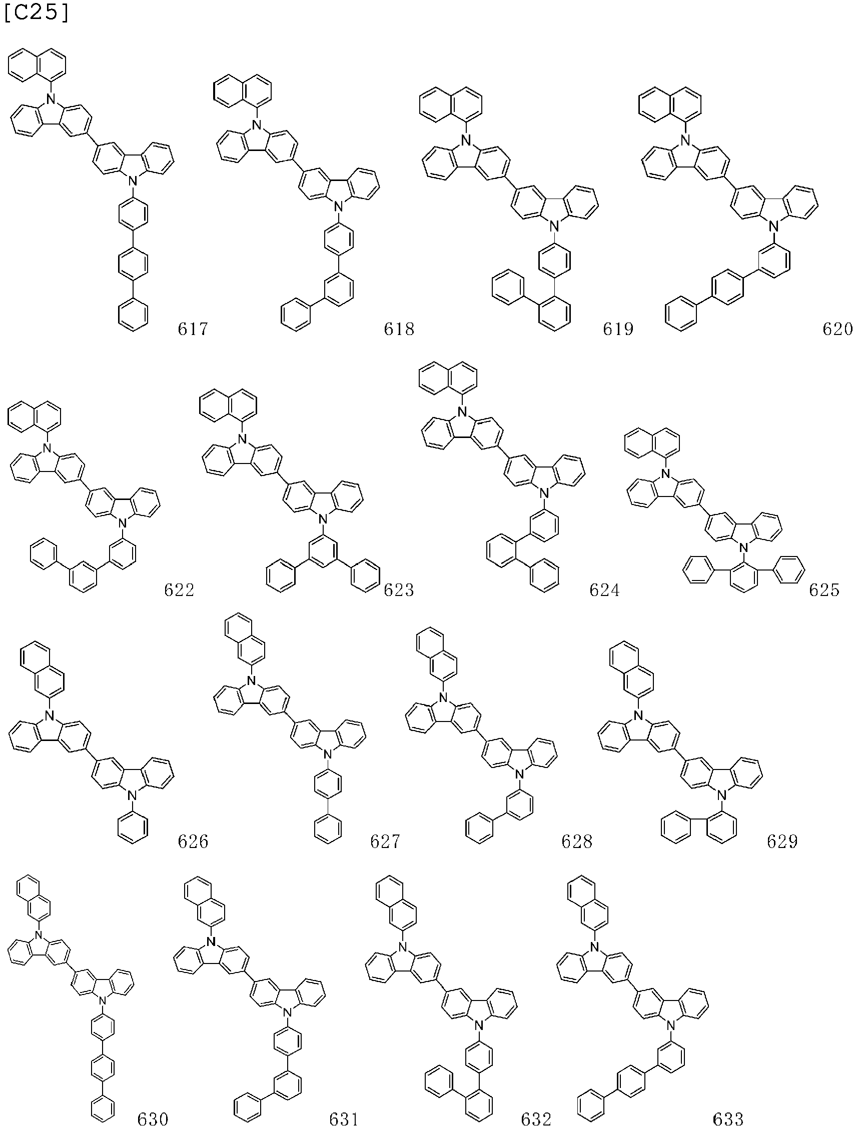

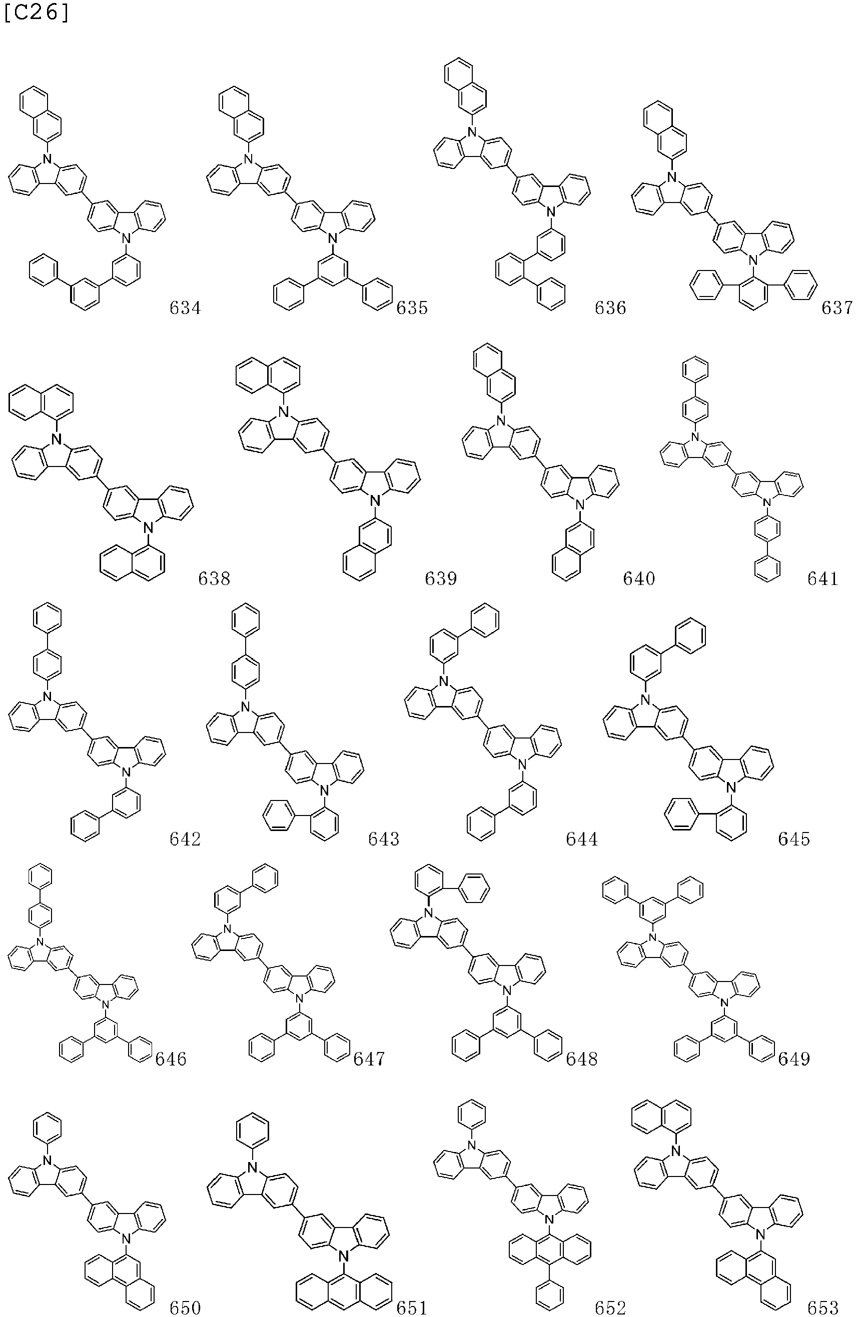

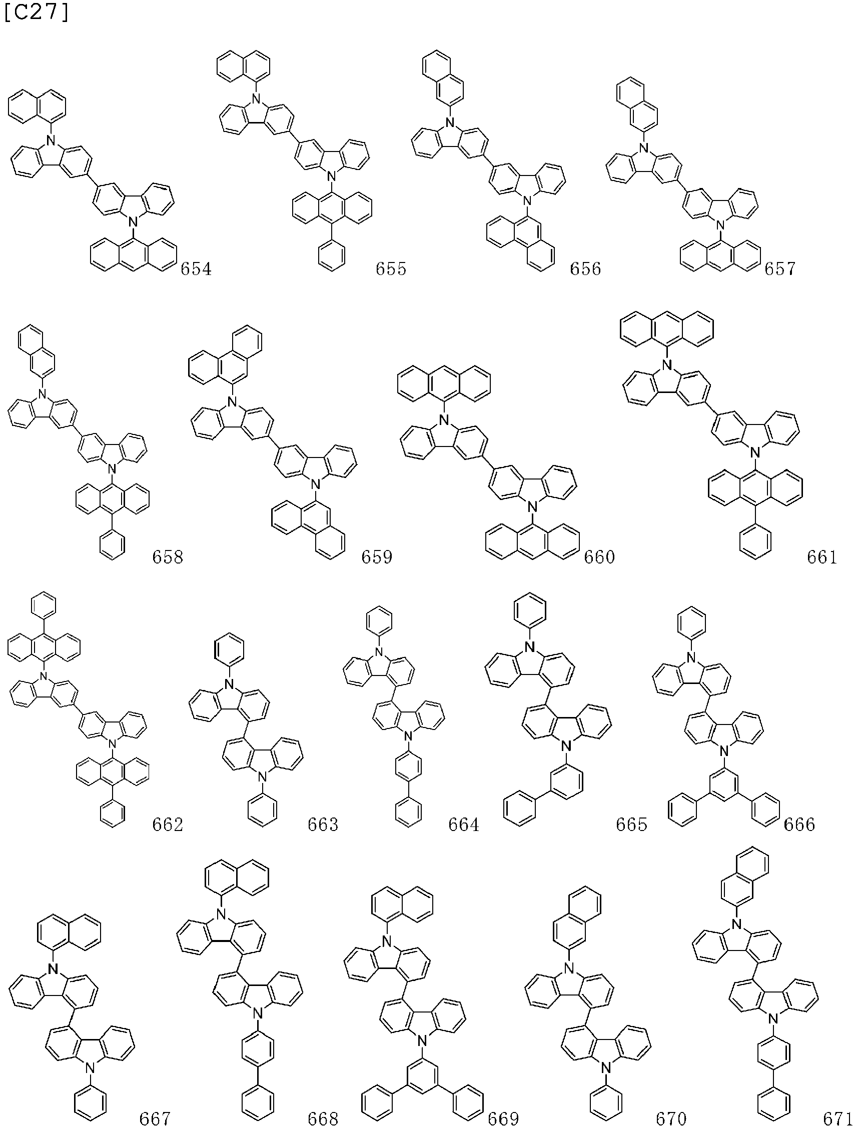

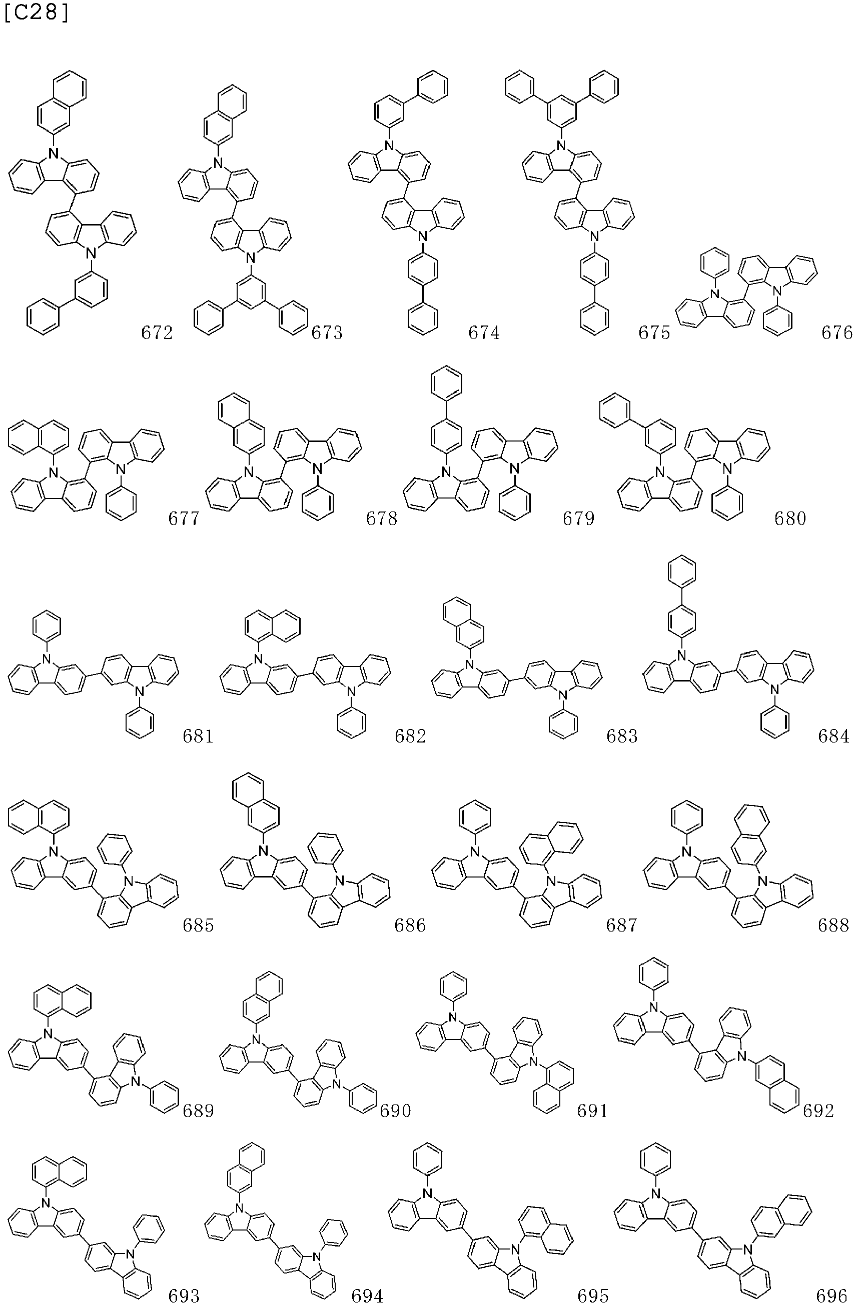

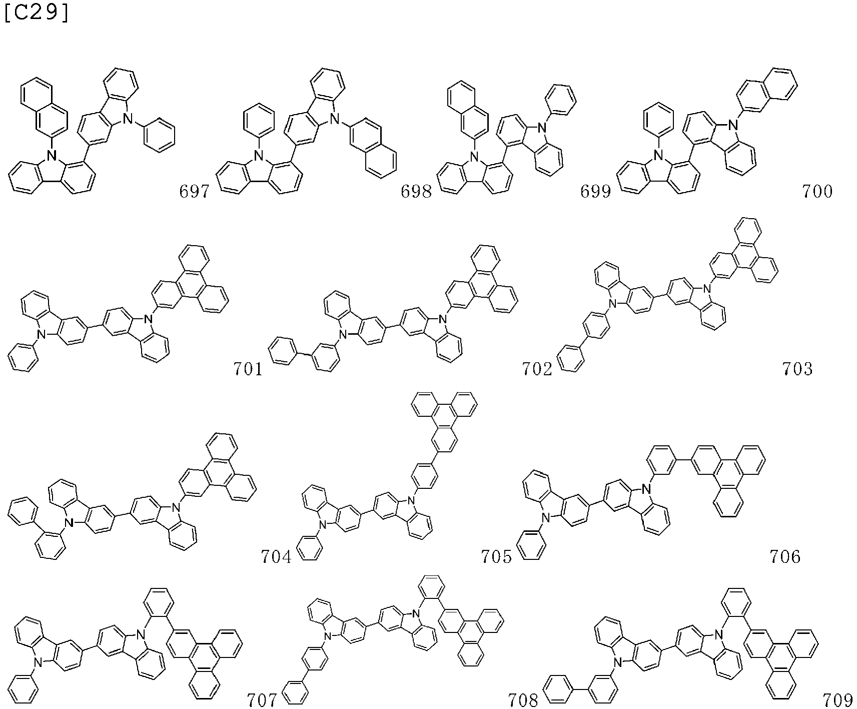

The organic EL device of the present invention has a plurality of organic layers between electrodes opposite to each other, wherein at least one of the organic layers is a light-emitting layer. Such at least one light-emitting layer contains the first host, the second host, and at least one light-emitting dopant.

Next, the structure of the organic EL device of the present invention will be described by referring to the drawing, but the structure of the organic EL device of the present invention is not limited thereto.

Figure 1 is a cross-sectional view showing a structure example of an organic EL device generally used for the present invention, in which there are indicated a substrate 1, an anode 2, a hole injection layer 3, a hole transport layer 4, a light-emitting layer 5, an electron transport layer 6, and a cathode 7. The organic EL device of the present invention may have an exciton blocking layer adjacent to the light-emitting layer and may have an electron blocking layer between the light-emitting layer and the hole injection layer. The exciton blocking layer can be inserted into either of the anode side and the cathode side of the light-emitting layer and inserted into both sides at the same time. The organic EL device of the present invention has the anode, the light-emitting layer, and the cathode as essential layers, and preferably has a hole injection transport layer and an electron injection transport layer in addition to the essential layers, and further preferably has a hole blocking layer between the light-emitting layer and the electron injection transport layer. Note that the hole injection transport layer refers to either or both of a hole injection layer and a hole transport layer, and the electron injection transport layer refers to either or both of an electron injection layer and an electron transport layer.

A structure reverse to that of Figure 1 is applicable, in which a cathode 7, an electron transport layer 6, a light-emitting layer 5, a hole transport layer 4, and an anode 2 are laminated on a substrate 1 in this order. In this case, layers may be added or omitted as necessary.

### - Substrate -

The organic EL device of the present invention is preferably supported on a substrate. The substrate is not particularly limited, and those conventionally used in organic EL devices may be used, and substrates made of, for example, glass, a transparent plastic, or quartz may be used.

### - Anode -

Regarding an anode material for an organic EL device, it is preferable to use a material of a metal, an alloy, an electrically conductive compound, and a mixture thereof, each having a large work function (4 eV or more). Specific examples of such an electrode material include a metal such as Au, and a conductive transparent material such as CuI, indium tin oxide (ITO), SnO₂, and ZnO. In addition, an amorphous material such as IDIXO (In₂O₃-ZnO), which is capable of forming a transparent conductive film, may be used. Regarding the anode, such an electrode material is used to form a thin film by, for example, a vapor-deposition or sputtering method, and a desired shape pattern may be formed by a photolithographic method; or if the pattern accuracy is not particularly required (about 100 µm or more), a pattern may be formed via a desired shape mask when the electrode material is vapor-deposited or sputtered. Alternatively, when a coatable substance such as an organic conductive compound is used, a wet film formation method such as a printing method or a coating method may be used. For taking emitted light from the anode, it is desired to have a transmittance of more than 10%, and the sheet resistance for the anode is preferably several hundreds Ω/□ or less. The film thickness is selected usually within 10 to 1000 nm, preferably within 10 to 200 nm though depending on the material.

### - Cathode -

Meanwhile, regarding a cathode material, a material of a metal (an electron injection metal), an alloy, an electrically conductive compound, or a mixture thereof, each having a small work function (4 eV or less) is used. Specific examples of such an electrode material include sodium, a sodium-potassium alloy, magnesium, lithium, a magnesium/copper mixture, a magnesium/silver mixture, a magnesium/aluminum mixture, a magnesium/indium mixture, an aluminum/aluminum oxide (Al₂O₃) mixture, indium, a lithium/aluminum mixture, and a rare earth metal. Among these, from the viewpoint of the electron injectability and the durability against oxidation and the like, a mixture of an electron injection metal and a second metal which is a stable metal having a larger work function value is suitable, and examples thereof include a magnesium/silver mixture, a magnesium/aluminum mixture, a magnesium/indium mixture, an aluminum/aluminum oxide mixture, a lithium/aluminum mixture and aluminum. The cathode can be produced by forming a thin film by a method such as vapor-depositing or sputtering of such a cathode material. In addition, the sheet resistance of cathode is preferably several hundreds Ω/□ or less. The film thickness is selected usually within 10 nm to 5 µm, preferably within 50 to 200 nm. Note that for transmission of emitted light, if either one of the anode and cathode of the organic EL device is transparent or translucent, emission luminance is improved, which is convenient.

In addition, formation of a film of the above metal with a thickness of 1 to 20 nm, followed by formation of a conductive transparent material described in the description on the anode thereon, enables production of a transparent or translucent cathode, and application of this enables production of a device wherein an anode and a cathode both have transmittance.

### - Light-emitting layer -

The light-emitting layer is a layer that emits light after excitons are generated when holes and electrons injected from the anode and the cathode, respectively, are recombined. As a light-emitting layer, a light-emitting dopant material and a host are contained.

As a host, the first host and the second host are used.

As the first host represented by the general formula (1), one kind thereof may be used, or two or more kinds of different compounds may be used. Similarly, as the second host represented by the general formula (2), one kind thereof may be used, or two or more kinds of different compounds may be used.

If necessary, one, or two or more other known host materials may be used in combination; however, it is preferable that an amount thereof to be used be 50 wt% or less, preferably 25 wt% or less based on the host materials in total.

A preferred method as the method for producing the organic EL device of the present invention is a method comprising providing a premixture comprising the first host and the second host and producing a light-emitting layer by use of the premixture. Additionally, a more preferred method comprises vapor-depositing the premixture by vaporization from a single evaporation source. Herein, the premixture is suitably a uniform composition.

When the first host and the second host are premixed and used, it is desirable that a difference in 50% weight reduction temperature (T₅₀) be small in order to produce an organic EL device having favorable characteristics with high reproducibility. The 50% weight reduction temperature is a temperature at which the weight is reduced by 50% when the temperature is raised to 550°C from room temperature at a rate of 10°C/min in TG-DTA measurement under a nitrogen stream reduced pressure (1 Pa). It is considered that vaporization due to evaporation or sublimation the most vigorously occurs around this temperature.

The difference in 50% weight reduction temperatures of the first host and the second host in the premixture is preferably within 20°C. The premixture can be vaporized from a single evaporation source and vapor-deposited to thereby obtain a uniform vapor-deposited film. In this case, the premixture may be mixed with a light-emitting dopant material necessary for formation of a light-emitting layer, or another host to be used as necessary. However, when there is a large difference in temperatures to provide desired vapor pressure, vapor-deposition may be performed from another vapor deposition source.

In addition, regarding the mixing ratio (weight ratio) between the first host and the second host, the proportion of the first host may be 10 to 70%, and is preferably more than 15% and less than 65%, more preferably 20 to 60% based on the first host and the second host in total.

The premixing method is desirably a method that can allow for mixing as uniformly as possible, and examples thereof include pulverization and mixing, a heating and melting method under reduced pressure or under an atmosphere of an inert gas such as nitrogen, and sublimation, but not limited thereto.

The host and the premixture thereof may be in powder, stick, or granule form.

In the case of use of a plurality of kinds of hosts, such respective hosts can be vapor-deposited from different vapor deposition sources or can be simultaneously vapor-deposited from one vapor deposition source by premixing the hosts before vapor deposition to provide a premixture.

When a phosphorescent dopant is used as a light-emitting dopant material, preferred is a phosphorescent dopant including an organic metal complex containing at least one metal selected from ruthenium, rhodium, palladium, silver, rhenium, osmium, iridium, platinum and gold. Specifically, iridium complexes described in J. Am. Chem. Soc. 2001, 123, 4304, JP2013-530515A, US2016/0049599A, US2017/0069848A, US2018/0282356A, US2019/0036043A, and the like, or platinum complexes described in US2018/0013078A, KR2018-094482A, and the like are preferably used, but the phosphorescent dopant material is not limited thereto.

Regarding the phosphorescent dopant material, only one kind thereof may be contained in the light-emitting layer, or two or more kinds thereof may be contained. A content of the phosphorescent dopant material is preferably 0.1 to 30 wt% and more preferably 1 to 20 wt% with respect to the host material.

The phosphorescent dopant material is not particularly limited, and specific examples thereof include the following.

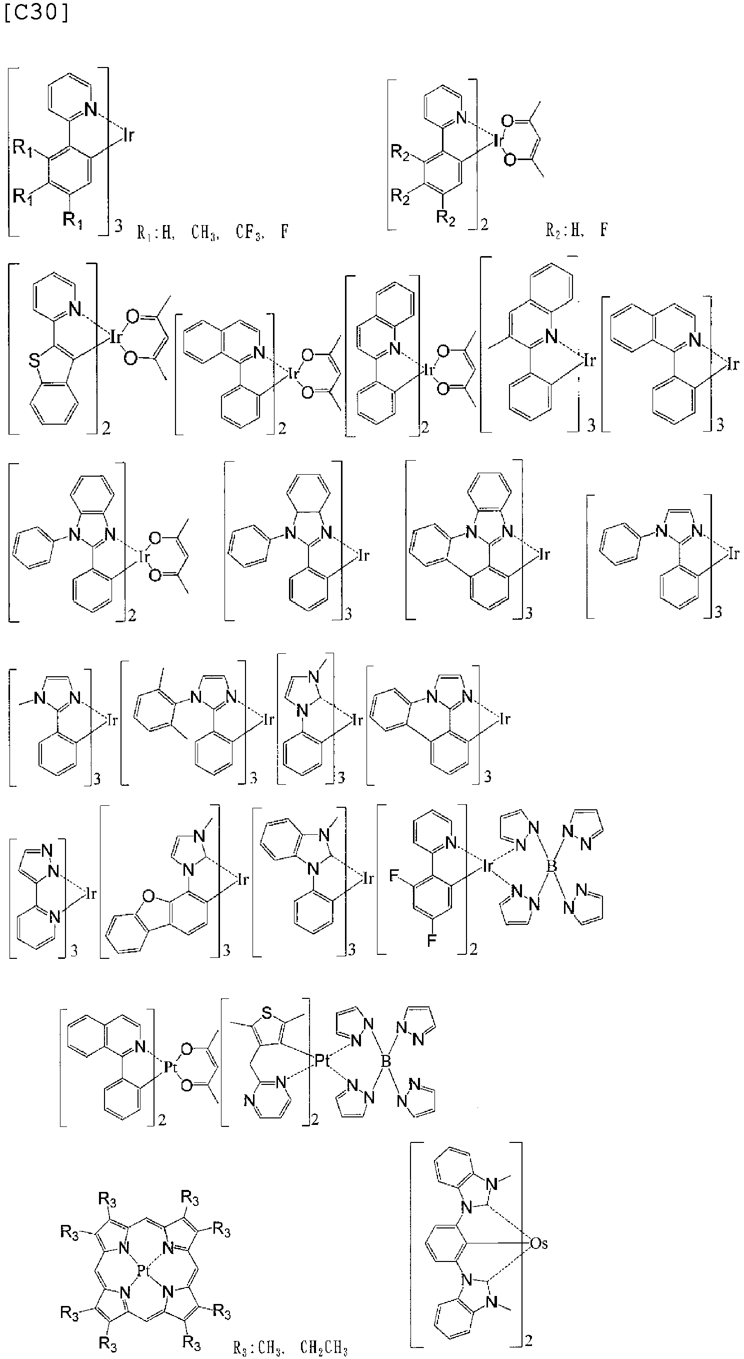

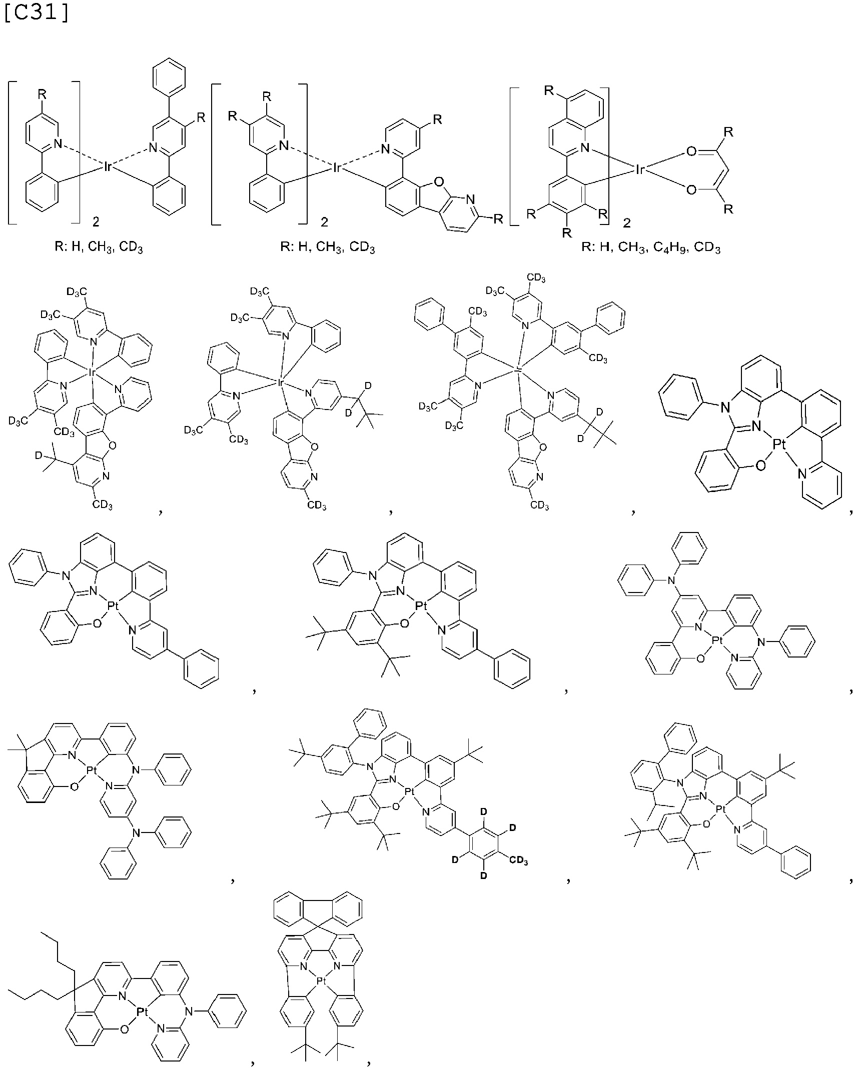

When a fluorescence-emitting dopant is used as the light-emitting dopant material, the fluorescence-emitting dopant is not particularly limited. Examples thereof include benzoxazole derivatives, benzothiazole derivatives, benzimidazole derivatives, styrylbenzene derivatives, polyphenyl derivatives, diphenylbutadiene derivatives, tetraphenyl butadiene derivatives, naphthalimido derivatives, coumarin derivatives, fused aromatic compounds, perinone derivatives, oxadiazole derivatives, oxazine derivatives, aldazine derivatives, pyrrolidine derivatives, cyclopentadiene derivatives, bisstyryl anthracene derivatives, quinacridone derivatives, pyrrolopyridine derivatives, thiadiazolopyridine derivatives, styrylamine derivatives, diketopyrrolopyrrole derivatives, aromatic dimethylidine compounds, metal complexes of 8-quinolinol derivatives or metal complexes of pyromethene derivatives, rare earth complexes, various metal complexes represented by transition metal complexes, polymer compounds such as polythiophene, polyphenylene, and polyphenylene vinylene, and organosilane derivatives. Preferred examples thereof include fused aromatic derivatives, styryl derivatives, diketopyrrolopyrrole derivatives, oxazine derivatives, pyromethene metal complexes, transition metal complexes, and lanthanoid complexes. More preferable examples thereof include naphthalene, pyrene, chrysene, triphenylene, benzo[c]phenanthrene, benzo[a]anthracene, pentacene, perylene, fluoranthene, acenaphthofluoranthene, dibenzo[a,j]anthracene, dibenzo[a,h]anthracene, benzo[a]naphthalene, hexacene, naphtho[2,1-f]isoquinoline, α-naphthaphenanthridine, phenanthrooxazole, quinolino[6,5-f]quinoline, and benzothiophanthrene. These may have an alkyl group, an aryl group, an aromatic heterocyclic group, or a diarylamino group as a substituent.

When a thermally activated delayed fluorescence-emitting dopant is used as the light-emitting dopant material, the thermally activated delayed fluorescence-emitting dopant is not particularly limited. Examples thereof include: metal complexes such as a tin complex and a copper complex; indolocarbazole derivatives described in WO2011/070963A; cyanobenzene derivatives and carbazole derivatives described in Nature 2012, 492, 234; and phenazine derivatives, oxadiazole derivatives, triazole derivatives, sulfone derivatives, phenoxazine derivatives, and acridine derivatives described in Nature Photonics 2014, 8,326.

The thermally activated delayed fluorescence-emitting dopant material is not particularly limited, and specific examples thereof include the following.

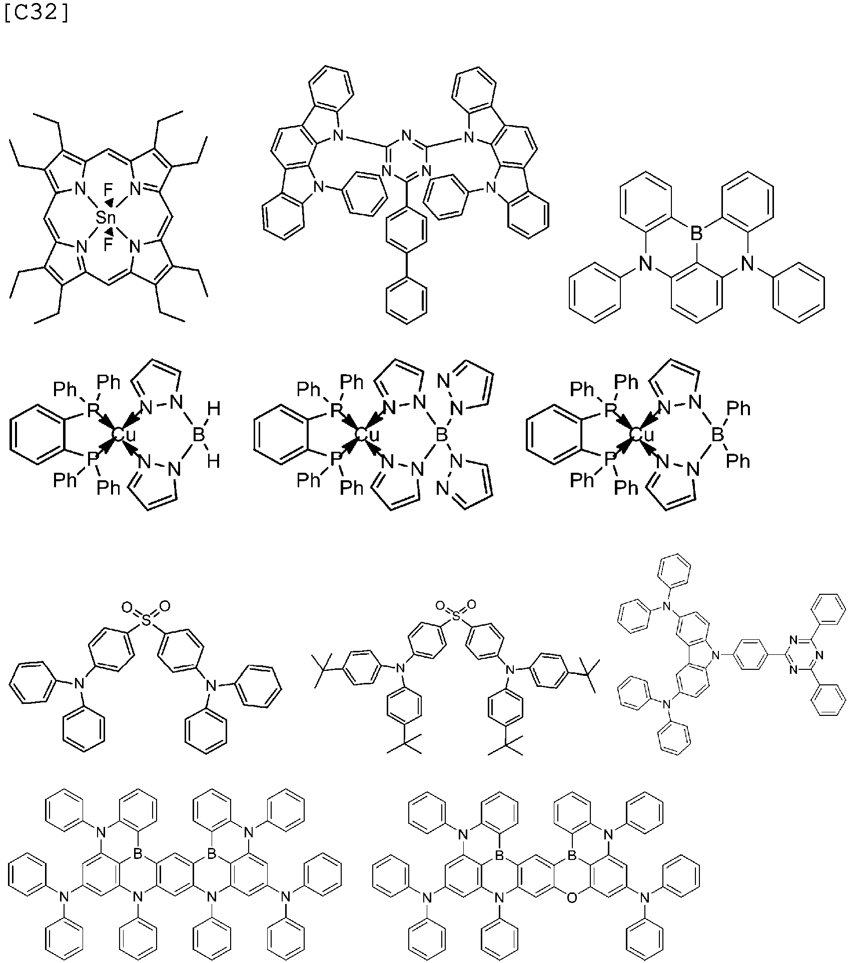

Regarding the thermally activated delayed fluorescence-emitting dopant material, only one kind thereof may be contained in the light-emitting layer, or two or more kinds thereof may be contained. In addition, the thermally activated delayed fluorescence-emitting dopant may be used by mixing with a phosphorescent dopant and a fluorescence-emitting dopant. A content of the thermally activated delayed fluorescence-emitting dopant material is preferably 0.1% to 50% and more preferably 1% to 30% with respect to the host material.

### - Injection Layer -

The injection layer is a layer that is provided between an electrode and an organic layer in order to lower a driving voltage and improve emission luminance, and includes a hole injection layer and an electron injection layer, and may be present between the anode and the light-emitting layer or the hole transport layer, and between the cathode and the light-emitting layer or the electron transport layer. The injection layer can be provided as necessary.

### - Hole Blocking Layer -

The hole blocking layer has a function of the electron transport layer in a broad sense, and is made of a hole blocking material having a function of transporting electrons and a significantly low ability to transport holes, and can block holes while transporting electrons, thereby improving a probability of recombining electrons and holes in the light-emitting layer.

### - Electron Blocking Layer -

The electron blocking layer has a function of a hole transport layer in a broad sense and blocks electrons while transporting holes, thereby enabling a probability of recombining electrons and holes in the light-emitting layer to be improved.

Regarding the material of the electron blocking layer, a known electron blocking layer material can be used and a material of the hole transport layer to be described below can be used as necessary. A film thickness of the electron blocking layer is preferably 3 to 100 nm, and more preferably 5 to 30 nm.

### - Exciton Blocking Layer -

The exciton blocking layer is a layer for preventing excitons generated by recombination of holes and electrons in the light-emitting layer from being diffused in a charge transport layer, and insertion of this layer allows excitons to be efficiently confined in the light-emitting layer, enabling the luminous efficiency of the device to be improved. The exciton blocking layer can be inserted, in a device having two or more light-emitting layers adjacent to each other, between two adjacent light-emitting layers.

Regarding the material of the exciton blocking layer, a known exciton blocking layer material can be used. Examples thereof include 1,3-dicarbazolyl benzene (mCP) and bis(8-hydroxy-2-methylquinoline)-(4-phenylphenoxy)aluminum (III) (BAlq).

### - Hole Transport Layer -

The hole transport layer is made of a hole transport material having a function of transporting holes, and the hole transport layer can be provided as a single layer or a plurality of layers.

The hole transport material has either hole injection, transport properties or electron barrier properties, and may be an organic material or an inorganic material. For the hole transport layer, any one selected from conventionally known compounds can be used. Examples of such a hole transport material include porphyrin derivatives, arylamine derivatives, triazole derivatives, oxadiazole derivatives, imidazole derivatives, polyarylalkane derivatives, pyrazoline derivatives and pyrazolone derivatives, phenylenediamine derivatives, arylamine derivatives, amino-substituted chalcone derivatives, oxazole derivatives, styryl anthracene derivatives, fluorenone derivatives, hydrazone derivatives, stilbene derivatives, silazane derivatives, an aniline copolymer, and a conductive polymer oligomer, and particularly a thiophene oligomer. Use of porphyrin derivatives, arylamine derivatives, or styrylamine derivatives is preferred. Use of arylamine compounds is more preferred.

### - Electron Transport Layer -

The electron transport layer is made of a material having a function of transporting electrons, and the electron transport layer can be provided as a single layer or a plurality of layers.

The electron transport material (which may also serve as a hole blocking material) may have a function of transferring electrons injected from the cathode to the light-emitting layer. For the electron transport layer, any one selected from conventionally known compounds can be used, and examples thereof include polycyclic aromatic derivatives such as naphthalene, anthracene, and phenanthroline, tris(8-hydroxyquinoline)aluminum (III) derivatives, phosphine oxide derivatives, nitro-substituted fluorene derivatives, diphenylquinone derivatives, thiopyrandioxide derivatives, carbodiimide, fluorenylidene methane derivatives, anthraquinodimethane and anthrone derivatives, bipyridine derivatives, quinoline derivatives, oxadiazole derivatives, benzimidazole derivatives, benzothiazole derivatives, and indolocarbazole derivatives. In addition, a polymer material in which the above material is introduced into a polymer chain or the above material is used for a main chain of a polymer can be used.

### Examples

Hereafter, the present invention will be described in detail by referring to Examples, but the present invention is not limited these Examples and can be implemented in various forms without departing from the gist thereof.

### Synthesis Example

Compound (82) was synthesized in accordance with the next reaction formula.

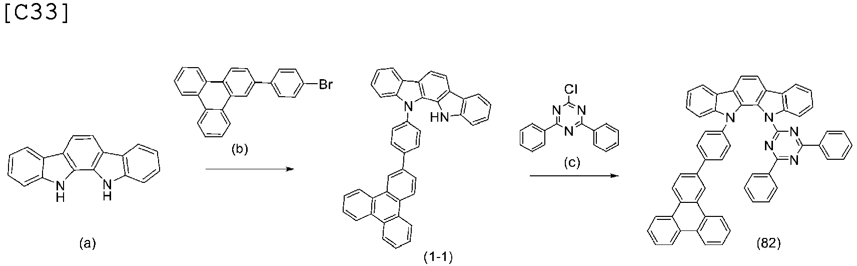

To 20 g of compound (a) were added 36 g of compound (b), 1.5 g of copper iodide, 43 g of potassium carbonate, 0.06 g of 18-crown-6-ether, and 900 ml of 1,3-dimethyl-2-imidazolidinone, and the mixture was stirred for 72 hours. The reaction product was separated and purified to give 32 g (73% yield) of intermediate (1-1) as a white solid.

To 30 ml of N,N'-dimethylacetamide (DMAc) was added 1.4 g of 60 wt% sodium hydride, and 17 g of intermediate (1-1) dissolved in DMAc was added thereto, and the mixture was stirred for 30 minutes. To this was added 7.9 g of compound (c), then the mixture was stirred for 4 hours. The reaction product was separated and purified to give 18 g of compound (82) as a yellow solid compound.

### Example 1

On a glass substrate on which an anode made of ITO with a film thickness of 110 nm was formed, respective thin films were laminated by a vacuum evaporation method at a degree of vacuum of 4.0 × 10⁻⁵ Pa. First, HAT-CN was formed with a thickness of 25 nm as a hole injection layer on ITO, and next, Spiro-TPD was formed with a thickness of 30 nm as a hole transport layer. Next, HT-1 was formed with a thickness of 10 nm as an electron blocking layer. Then, compound 82 as a first host, compound 602 as a second host and Ir(ppy)₃ as a light-emitting dopant were co-vapor-deposited from different vapor deposition sources, respectively, to form a light-emitting layer with a thickness of 40 nm. In this case, co-vapor deposition was performed under vapor deposition conditions such that the concentration of Ir(ppy)₃ was 10 wt%, and the weight ratio between the first host and the second host was 30:70. Next, ET-1 was formed with a thickness of 20 nm as an electron transport layer. Further, LiF was formed with a thickness of 1 nm as an electron injection layer on the electron transport layer. Finally, Al was formed with a thickness of 70 nm as a cathode on the electron injection layer to produce an organic EL device.

### Examples 2 to 11

Organic EL devices were produced in the same manner as in Example 1 except that compounds shown in Table 1 were used as the first host and the second host and the weight ratio was as shown in Table 1.

### Examples 12 to 13

Organic EL devices were produced in the same manner as in Example 1 except that a premixture obtained by weighing a first host and a second host shown in Table 1 at a weight ratio shown in Table 1 and mixing them while grinding in a mortar was vapor-deposited from one vapor deposition source.

### Comparative Example 1

An organic EL device was produced in the same manner as in Example 1 except that only a first host shown in Table 1 was used as a host compound.

### Comparative Examples 2 to 5

Organic EL devices were produced in the same manner as in Example 1 except that compounds shown in Table 1 were used as the first host and the second host and the weight ratio was as shown in Table 1.

### Comparative Examples 6 to 7

Organic EL devices were produced in the same manner as in Example 12 or 13 except that compounds shown in Table 1 were used as the first host and the second host and the weight ratio was as shown in Table 1.

Evaluation results of the produced organic EL devices are shown in Table 1. In the table, the luminance, driving voltage, power efficiency, and LT70 are values at a driving current of 20 mA/cm². LT70 is a time period needed for the initial luminance (Luminance described in the table) to be reduced to 70% thereof, and it represents lifetime characteristics. The numbers with which the first host and the second host are marked are numbers with which the exemplified compounds are marked.

**[Table 1]**

| | First host | Second host | Weight ratio | Voltage (V) | Luminance (cd/m²) | Power efficiency (Im/W) | LT70 (h) |
|---|---|---|---|---|---|---|---|
| Example 1 | 82 | 602 | 30:70 | 4.4 | 9675 | 34.5 | 2527 |
| Example 2 | 279 | 602 | 30:70 | 4.6 | 9879 | 33.6 | 2450 |
| Example 3 | 83 | 641 | 30:70 | 4.4 | 10271 | 36.6 | 2527 |
| Example 4 | 84 | 602 | 30:70 | 4.5 | 10512 | 36.4 | 2422 |
| Example 5 | 132 | 642 | 30:70 | 4.3 | 10080 | 36.8 | 2361 |
| Example 6 | 273 | 642 | 30:70 | 4.5 | 10027 | 35.3 | 2254 |
| Example 7 | 310 | 641 | 30:70 | 4.3 | 9812 | 35.8 | 2589 |
| Example 8 | 316 | 641 | 30:70 | 4.3 | 9823 | 35.9 | 2585 |
| Example 9 | 318 | 641 | 30:70 | 4.2 | 9623 | 36.0 | 2599 |
| Example 10 | 301 | 602 | 50:50 | 4.2 | 10649 | 39.9 | 1492 |
| Example 11 | 83 | 641 | 50:50 | 4.1 | 10663 | 41.0 | 1742 |
| Example 12 | 83 | 641 | 30:70 | 4.4 | 10312 | 36.4 | 2606 |
| Example 13 | 83 | 641 | 50:50 | 4.2 | 11036 | 41.7 | 1868 |
| Comp. Example 1 | 301 | - | - | 3.9 | 10188 | 40.6 | 441 |
| Comp. Example 2 | A | 601 | 30:70 | 4.7 | 9817 | 32.5 | 1163 |
| Comp. Example 3 | B | 602 | 30:70 | 4.6 | 9747 | 33.2 | 2154 |
| Comp. Example 4 | C | 602 | 50:50 | 4.1 | 10541 | 39.9 | 631 |
| Comp. Example 5 | D | 642 | 30:70 | 5.2 | 10122 | 30.4 | 1579 |
| Comp. Example 6 | B | 602 | 30:70 | 4.4 | 9760 | 35.0 | 649 |
| Comp. Example 7 | D | 642 | 50:50 | 4.6 | 11045 | 37.5 | 997 |

From the results in Table 1, it is understood that Examples 1 to 13 improved the efficiency and the lifetime and exhibited good characteristics, as compared with Comparative Examples.

Compounds used in Examples are shown below.

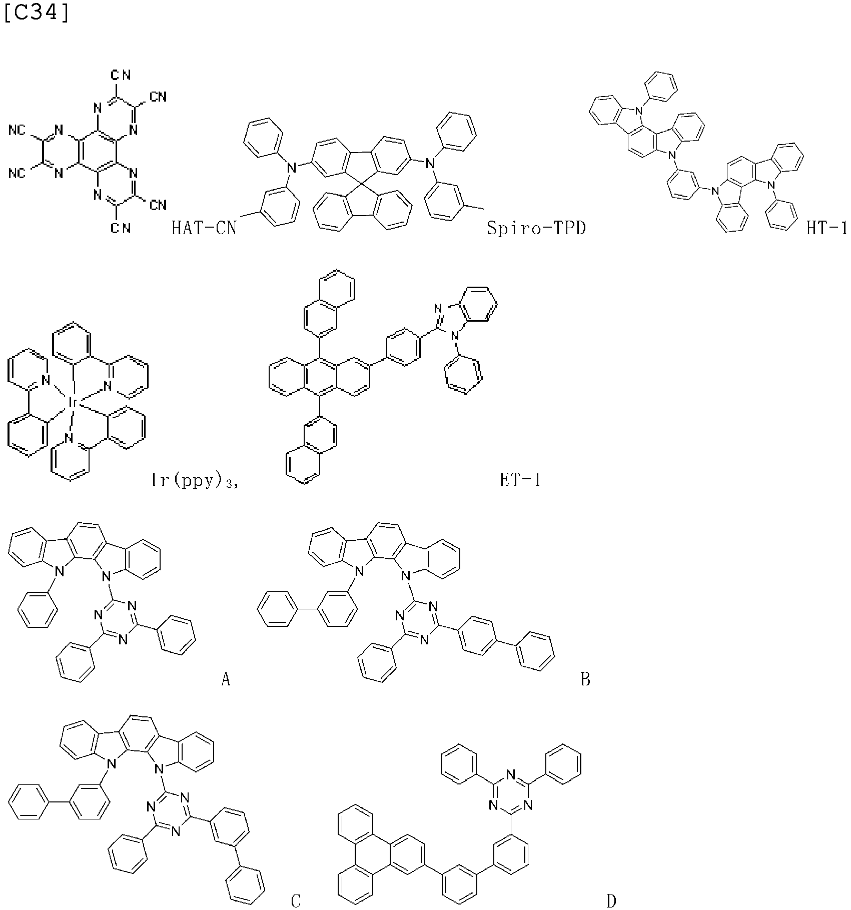

Table 2 shows the 50% weight reduction temperatures (T₅₀) of compounds 83, 602, 641, 642 B and D.

**[Table 2]**

| Compound | T₅₀[°C] |
|---|---|
| 83 | 308 |
| 602 | 277 |
| 641 | 321 |
| 642 | 319 |
| B | 278 |
| D | 322 |

## Claims

1. An organic electroluminescent device comprising one or more light-emitting layers between an anode and a cathode opposed to each other, wherein at least one of the light-emitting layers contains a first host selected from a compound represented by the following general formula (1), a second host selected from a compound represented by the following general formula (2), and a light-emitting dopant material: 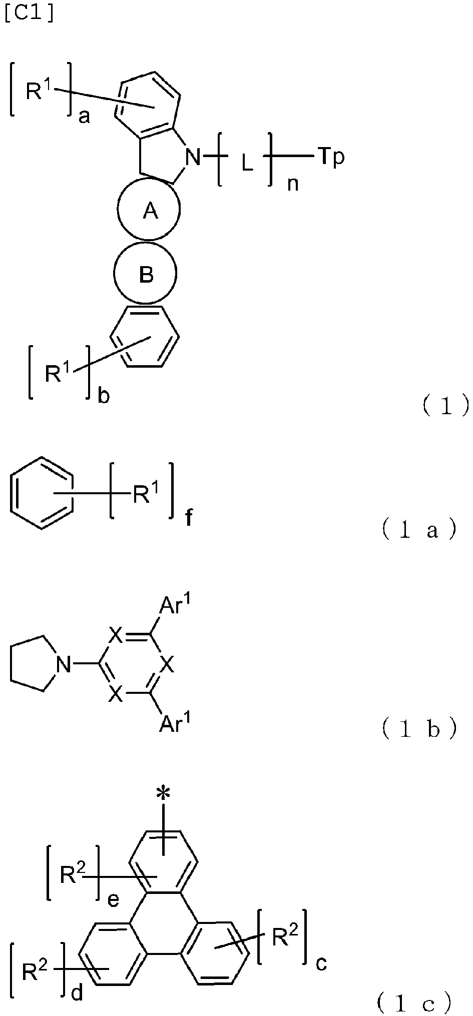
wherein a ring A is an aromatic ring represented by formula (1a), a ring B is a heterocycle represented by formula (1b), Tp represents a triphenylene group represented by formula (1c), and * represents a position for binding to L,
each R¹ independently represents deuterium, or an aliphatic hydrocarbon group having 1 to 10 carbon atoms,
L represents a substituted or unsubstituted aromatic hydrocarbon group having 6 to 18 carbon atoms,
each X independently represents N or C-H and at least one thereof represents N,
each Ar¹ independently represents hydrogen, a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five of these aromatic rings are linked to each other,
each R² independently represents deuterium, an aliphatic hydrocarbon group having 1 to 10 carbon atoms, a substituted or unsubstituted aromatic hydrocarbon group having 6 to 10 carbon atoms, a substituted or
unsubstituted aromatic heterocyclic group having 3 to 17 carbon atoms, or a substituted or unsubstituted linked aromatic group in which two to five aromatic rings of aromatic groups selected from the aromatic hydrocarbon group and the aromatic heterocyclic group are linked to each other, and
a to f represent the number of substitutions, a to d represent an integer of 0 to 4, e represents an integer of 0 to 3, and f represents an integer of 0 to 2, and n represents the number of repetitions and an integer of 0 to 3; 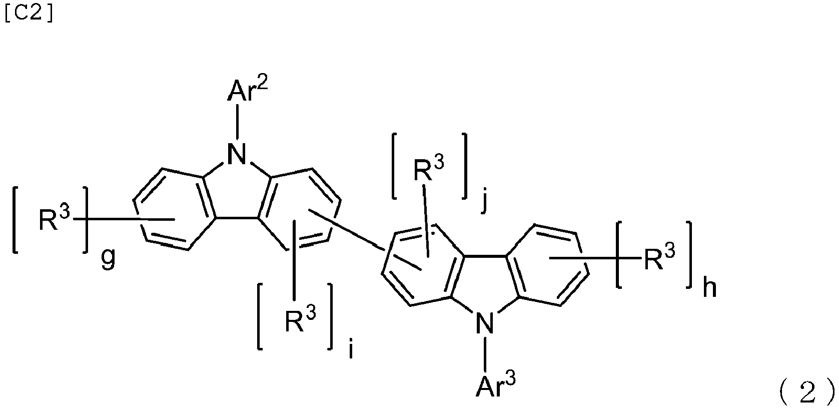
wherein Ar² and Ar³ each independently represent a substituted or unsubstituted aromatic hydrocarbon group having 6 to 18 carbon atoms, a substituted or
unsubstituted aromatic heterocyclic group having 3 to 17 carbon atoms, or a substituted or unsubstituted linked aromatic group in which two to five of these aromatic groups are linked to each other,
each R³ independently represents deuterium, an aliphatic hydrocarbon group having 1 to 10 carbon atoms, a substituted or unsubstituted aromatic hydrocarbon group having 6 to 18 carbon atoms, or a substituted or
unsubstituted aromatic heterocyclic group having 3 to 17 carbon atoms, and
g to j represent the number of substitutions, g and h represent an integer of 0 to 4, and i and j represent an integer of 0 to 3.

2. The organic electroluminescent device according to claim 1, wherein all of X represent N.

3. The organic electroluminescent device according to claim 1 or 2, wherein L represents a substituted or unsubstituted phenylene group.

4. The organic electroluminescent device according to any one of claims 1 to 3, wherein n represents 0 or 1.

5. The organic electroluminescent device according to any one of claims 1 to 4, wherein all of a to f represent 0.

6. The organic electroluminescent device according to any one of claims 1 to 5, wherein the compound represented by the general formula (1) is represented by any of the following formulas (3) to (6): 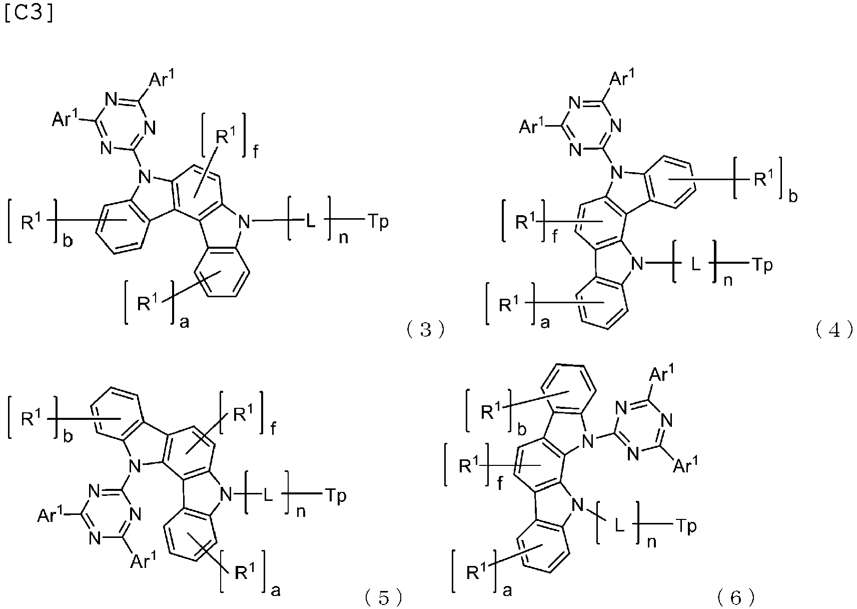 wherein Tp, Ar¹, L, R¹, a, b, f, and n are as defined for the general formula (1).

7. A compound for the organic electroluminescent device according to any one of claims 1 to 6, wherein Tp in the general formula (1) and the formulas (3) to (6) is represented by the following formula (1d): 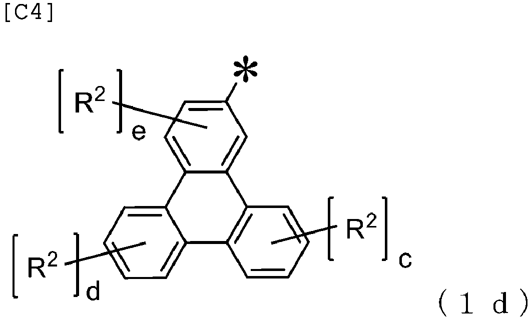 wherein R², c, d, and e are as defined for the general formula (1).

8. The organic electroluminescent device according to any one of claims 1 to 7, wherein n in the general formula (1) and the formulas (3) to (6) is represents 1.

9. The organic electroluminescent device according to any one of claims 1 to 8, wherein the general formula (2) is represented by the following formula (7): 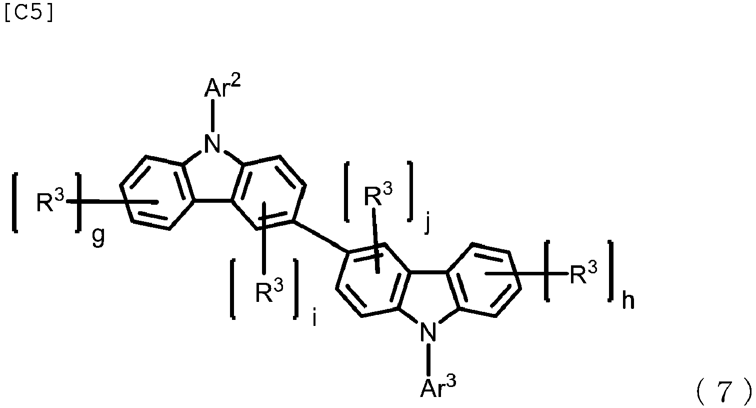 wherein Ar², Ar³, R³, and g to j are as defined for the general formula (2).

10. The organic electroluminescent device according to any one of claims 1 to 9, wherein Ar² and Ar³ each independently represent a substituted or unsubstituted phenyl group, biphenyl group or terphenyl group.

11. The organic electroluminescent device according to any one of claims 1 to 10, wherein all of g to j represent 0.

12. The organic electroluminescent device according to any one of claims 1 to 11, wherein the light-emitting dopant material is an organic metal complex containing at least one metal selected from ruthenium, rhodium, palladium, silver, rhenium, osmium, iridium, platinum and gold.

13. The organic electroluminescent device according to any one of claims 1 to 11, wherein the light-emitting dopant material is a thermally activated delayed fluorescence-emitting dopant material.

14. A method for producing the organic electroluminescent device according to any one of claims 1 to 13, comprising a step of mixing the first host and the second host to form a premixture and then vapor-depositing a host material containing the premixture to form a light-emitting layer.

15. The method for producing the organic electroluminescent device according to claim 14, wherein a difference in 50% weight reduction temperatures of the first host and the second host is within 20°C.

16. A premixture comprising a first host and a second host that is for use in formation of a light-emitting layer of an organic electroluminescent device comprising, between an anode and a cathode opposed to each other, a light-emitting layer containing a host and a light-emitting dopant material,
wherein the first host is selected from a compound represented by the following general formula (1) and the second host is selected from a compound represented by the following general formula (2), and a difference in 50% weight reduction temperatures of the first host and the second host is within 20°C: 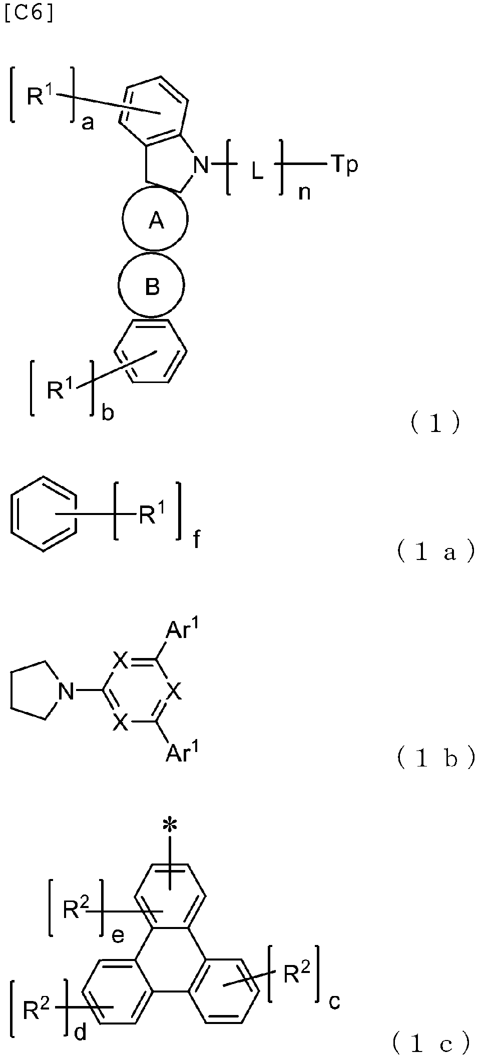
wherein a ring A is an aromatic ring represented by formula (1a), a ring B is a heterocycle represented by formula (1b), Tp represents a triphenylene group represented by formula (1c), and * represents a position for binding to L,
each R¹ independently represents deuterium, or an aliphatic hydrocarbon group having 1 to 10 carbon atoms, L represents a substituted or unsubstituted aromatic hydrocarbon group having 6 to 18 carbon atoms,
each X independently represents N or C-H and at least one thereof represents N,
each Ar¹ independently represents hydrogen, a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five of these aromatic rings are linked to each other,
each R² independently represents deuterium, an aliphatic hydrocarbon group having 1 to 10 carbon atoms, a substituted or unsubstituted aromatic hydrocarbon group having 6 to 10 carbon atoms, a substituted or unsubstituted aromatic heterocyclic group having 3 to 17 carbon atoms, or a substituted or unsubstituted linked aromatic group in which two to five aromatic rings of aromatic groups selected from the aromatic hydrocarbon group and the aromatic heterocyclic group are linked to each other, and
a to f represent the number of substitutions, a to d represent an integer of 0 to 4, e represents an integer of 0 to 3, and f represents an integer of 0 to 2, and n represents the number of repetitions and an integer of 0 to 3; 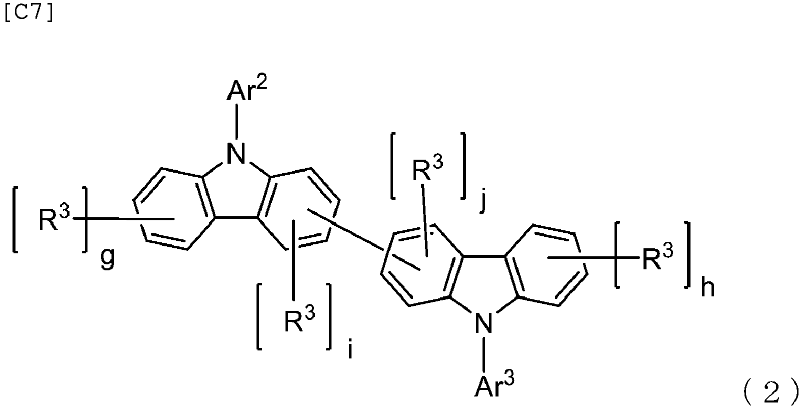
wherein Ar² and Ar³ each independently represent a substituted or unsubstituted aromatic hydrocarbon group having 6 to 18 carbon atoms, a substituted or unsubstituted aromatic heterocyclic group having 3 to 17 carbon atoms, or a substituted or unsubstituted linked aromatic group in which two to five of these aromatic groups are linked to each other,
each R³ independently represents deuterium, an aliphatic hydrocarbon group having 1 to 10 carbon atoms, a substituted or unsubstituted aromatic hydrocarbon group having 6 to 18 carbon atoms, or a substituted or unsubstituted aromatic heterocyclic group having 3 to 17 carbon atoms, and
g to j represent the number of substitutions, g and h represent an integer of 0 to 4, and i and j represent an integer of 0 to 3.
